(19) Europäisches Patentamt
European Patent Office
Office européen des brevets

(11) EP 0 672 945 B1

(12) # EUROPEAN PATENT SPECIFICATION

(45) Date of publication and mention of the grant of the patent:
**13.06.2001 Bulletin 2001/24**

(51) Int Cl.$^7$: **G03C 7/30**

(21) Application number: **95301637.5**

(22) Date of filing: **13.03.1995**

(54) **Silver halide color photographic light-sensitive material**

Farbphotographisches lichtempfindliches Silberhalogenidmaterial

Produit photographique couleur à l'halogénure d'argent sensible à la lumière

(84) Designated Contracting States:
**GB**

(30) Priority: **17.03.1994 JP 4724394**

(43) Date of publication of application:
**20.09.1995 Bulletin 1995/38**

(73) Proprietor: **KONICA CORPORATION**
**Tokyo 163 (JP)**

(72) Inventors:
- **Tosaka, Yasuo, c/o Konica Corp.**
**Odawara-shi, Kanagawa-ken (JP)**
- **Nonaka, Yoshiyuki, c/o Konica Corp.**
**Odawara-shi, Kanagawa-ken (JP)**
- **Hoshino, Keiichi, c/o Konica Corp.**
**Odawara-shi, Kanagawa-ken (JP)**

(74) Representative: **Watkins, David et al**
**Urquhart-Dykes & Lord,**
**30 Welbeck Street**
**London W1G 8ER (GB)**

(56) References cited:
**EP-A- 0 269 436**
**EP-A- 0 556 700**
**EP-A- 0 574 948**
**EP-A- 0 585 062**
**GB-A- 2 172 118**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 672 945 B1

Printed by Jouve, 75001 PARIS (FR)

## Description

### FIELD OF THE INVENTION

The present invention relates to a silver halide color photographic light-sensitive material suitable for use in preparing color proofs from plural pieces of halftone image information which are obtained by subjecting original images to color separation and halftone image conversion treatments in the color graphic arts/printing process.

### BACKGROUND OF THE INVENTION

There are methods for forming color images by using photopolymers or diazo compounds, called the overlay method and the surprint method, which are conventionally known as the methods for making color proofs from plural black-and-white halftone images prepared by subjecting originals to color separation and halftone image conversion treatments in the color graphic arts/printing process.

The overlay method is very simple, inexpensive for proof preparation, and advantageous in that all what has to be done for color proof reading is superpose film sheets for four different colors (subtractive three primary colors plus black), but has the disadvantage that the superposition of the film sheets brings about gloss, thus leading to providing an image quality different from that of the resulting print.

The surprint method is to superpose colored images on a support, and as the method there are those for forming a colored image by toner development, utilizing the adhesion property of a photopolymerizable material, as described in U.S. Patent Nos. 3,582,327, 3,607,264 and 3,620,726.

Japanese Patent Examined Publication (hereinafter abbreviated to JP E.P.) No. 27441/1972 and Japanese Patent Open to Public Inspection (hereinafter abbreviated to JP O.P.I.) No. 501217/1981 describe another color proof making method in which a light-sensitive colored sheet is used to have its layer transferred onto a support and subjected to exposure and development to form an image, then on the formed image layer is provided another light-sensitive colored sheet's layer to be subjected to similar process, and then repeating similar procedures, whereby a color proof is prepared.

JP O.P.I. No. 97140/1984 describes a method in which a colored light-sensitive sheet is exposed through a corresponding color-separation image film and developed to thereby form a colored image to be transferred onto a support, which is followed by forming and transferring onto the colored image in sequence different other colored images in the same manner, whereby a complete color image is formed on the support. For the toners and coloring agents for use in the formation of the above color image there may be used similar coloring materials to those for making printing inks, so that the resulting colors of the obtained color proof prepared by using them near those of actual prints.

The above-mentioned methods, however, require much labor for superposing and transferring images onto a support in the color proof making process, so that they have the disadvantage that they take time and are costly.

For solution to the above problems JP O.P.I Nos. 113139/1981, 104335/1981, 280746/1987, 280747/1987, 280748/1987, 280749/1987, 280750/1987 and 280849/1987 disclose methods for making color proofs by use of a silver halide color photographic light-sensitive material having a white support.

The method disclosed in the above publications is such that a plural number of color-separated black-and-white halftone dot images obtained by the color separation/halftone-image convertion of a colored original are printed in sequence in the contact printing manner onto a single sheet of color photographic paper, which is then subjected to color development to thereby form a color image composed of dyes produced from the couplers; the thus formed color image is used as a color proof.

The above technique, however, has the problem that when an attempt is made to reproduce neutral gray over the field including small, medium and large halftone dot areas, there occur slight differences in the halftone reproducibility between yellow, magenta and cyan colors to thus cause gray to be ill balanced or cause the gray reproducibility to be changed particularly when exposure or processing conditions fluctuate.

Further, there is a demand that the cyan, magenta and yellow colors of a color proof image be brought nearer to those of corresponding printing inks. It is, however, accompanied with a problem that the nearer to those of inks used the colors are, the more liable to vary the formed gray balance of the colors is due to fluctuation of processing or exposure conditions. In addition, the color proof having an image with its colors being brought closer to those of printing inks tends to become one with its black halftone lacking tight blackness.

For the formation of a cyan image, phenol or naphthol couplers are generally used. These couplers, however, have an undesirable absorption in the blue and green light spectral regions. Hence the coupler has the problem that the color resulting therefrom deviates from that of a corresponding color printing ink; solution to the problem is urgently needed.

As means to solve the above problem, the pyrazoloazole cyan couplers described in JP O.P.I. Nos. 552/1989,

553/1989, 554/1989, 555/1989, 556/1989, 556/1989, 557/1989 and 144057/1989; pyrazolotriazole cyan couplers described in JP O.P.I. No. 174429/1992, 230746/1992, 165172/1993, 204107/1993, 313324/1993 and 313325/1993; and the cyan couplers described in JP O.P.I. Nos. 133055/1992 and 232648/1993 are useful because they have excellent absorption characteristics with markedly reduced undesirable absorption in the blue and green spectral regions, and enable to obtain a color much comparable to that of a printing ink.

It has been found, however, that the use of the above couplers brings about a problem in the aforementioned halftone reproduction neutrality.

British Patent Application No. 2 172 118 discloses a photographic material suitable for color proofing comprising a magenta, a cyan and a yellow image forming silver halide emulsion layer and a separate black layer.

European Patent Application No. 0 556 700 and European Patent Application No. 0 574 948 disclose silver halide color photosensitive materials each comprising respective magenta, cyan and yellow image forming silver halide emulsion layers, and specified cyan couplers. The materials produced according to the teaching of these documents suffer from the same deficiencies as discussed above with regard to halftone neutrality.

## SUMMARY OF THE INVENTION

It is therefore an object of the invention to provide a light-sensitive material for color proof making use which is capable of stably giving a color proof having improved reproducibility of neutral gray of small-to-large halftone dots when used for color proof preparation from halftone image information obtained by the color separation and halftone image conversion with use of a silver halide color photographic light-sensitive material.

It is another object of the invention to provide a light-sensitive material for color proof making use which is capable of providing a color proof having approximate colors to those of printing inks.

It is a further object of the invention to provide a light-sensitive material for color proof making use which is capable of forming a color proof with its black halftone having tight blackness.

## DETAILED DESCRIPTION OF THE INVENTION

The above objects of the invention are accomplished by the following constituents:

(1) In a silver halide color photographic light-sensitive material comprising a support having thereon a silver halide emulsion layer for forming mainly a yellow image, a silver halide emulsion layer for forming mainly a magenta image, and a silver halide emulsion layer for forming mainly a cyan image,

said silver halide color photographic light-sensitive material, in which at least one of said silver halide emulsion layers comprises a silver halide emulsion having a spectral sensitivity having a portion common to the respective spectral sensitivity regions of said yellow, magenta and cyan image-forming silver halide emulsion layers, and said cyan image-forming layer comprises at least one of compounds represented by the following Formulas I to IV.

Formula I

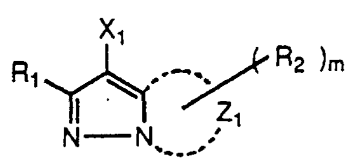

Formula II

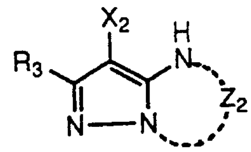

Formula III

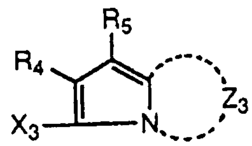

Formula IV

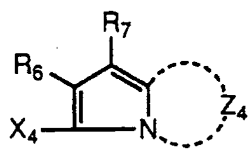

wherein $R_1$ represents a hydrogen atom or a substituent; $R_2$ is a substituent; m is the number of the substituents $R_2$, provided that when m is zero, $R_1$ represents an electron attractive group whose Hammett's substituent constant σp is not less than 0.20, while when m is 1 or 2 or more, at least either one of $R_1$ and $R_2$ is an electron attractive group having a Hammett's substituent constant σp of not less than 0.20;

$Z_1$ represents a group of non-metallic atoms necessary to form a nitrogen-containing 5-member heterocyclic ring;

$R_3$ represents a hydrogen atom or a substituent; $Z_2$ represents a group of non-metallic atoms necessary to condense with a pyrazole ring together with -NH- to form a nitrogen-containing 6-member heterocyclic ring;

$R_4$ and $R_5$ each represent an electron attractive group having a Hammett's substituent constant σp of not less than 0.20, provided the total σp value of $R_4$ and $R_5$ is not less than 0.65; $Z_3$ is a group of non-metallic atoms necessary to form a nitrogen-containing 5-member heterocyclic ring;

$R_6$ and $R_7$ each represent a hydrogen atom or a substituent; $Z_4$ is a group of non-metallic atoms necessary to form a nitrogen-containing 6-member ring; and

$X_1$, $X_2$, $X_3$ and $X_4$ each represent a hydrogen atom or a group capable of splitting upon coupling reaction with an oxidized product of a color developing agent.

(2) In a silver halide color photographic light-sensitive material comprising a support having thereon a silver halide emulsion layer for forming mainly a yellow image, a silver halide emulsion layer for forming mainly a magenta image and a silver halide emulsion layer for forming mainly a cyan image, wherein the cyan image forming silver halide emulsion layer contains at least one of compounds represented by the above Formulas I to IV, said silver halide color photographic light-sensitive material which comprises at least a layer for forming an image that absorbs a red light besides said three layers.

(3) The silver halide color photographic light-sensitive material according to the above (1) or (2), in which said light-sensitive material has a hydrophilic colloid layer containing a white pigment between the light-sensitive silver

halide emulsion layer located closest to said support and the emulsion layer-coated side surface of said support.
(4) The silver halide color photographic light-sensitive material of the above (1), (2) or (3), in which said light-sensitive material is exposed and processed in accordance with color-separated yellow image information, magenta image information and cyan image information to form a yellow image, a magenta image and a cyan image to thereby prepare a color proof.

The cyan coupler used in the invention includes polycycloheterocyclic compounds formed by the condensation with the nitrogen atom of a pyrrole or pyrazole ring, among which the preferred are those cyan couplers represented by the foregoing Formulas I through IV.

Firstly, the cyan coupler represented by Formula I is explained.

Examples of the substituent useful in the invention whose Hammett's substituent constant σp of +0.20 or above are sulfonyl, sulfinyl, sulfonyloxy, sulfamoyl, phosphoryl, carbamoyl, acyl, acyloxy, oxycarbonyl, carboxyl, cyano, nitro, halogenated alkyl halogenated alkoxy, halogenated aryloxy, pyrrolyl and tetrazolyl groups and a halogen atom.

The sulfonyl group includes alkylsulfonyl, arylsulfonyl, halogen-substituted alkylsulfonyl and halogen-substituted arylsulfonyl groups; the sulfinyl group includes alkylsulfinyl and arylsulfinyl groups; the sulfonyloxy group includes alkylsulfonyloxy and arylsulfonyloxy groups; the sulfamoyl group includes N,N-dialkylsulfamoyl, N,N-diarylsulfamoyl and N-alkyl-N-arylsulfamoyl groups; the phosphoryl group includes alkoxyphosphoryl, aryloxyphosphoryl, alkylphosphoryl and arylphosphoryl groups; the carbamoyl group includes N,N-dialkylcarbamoyl, N,N-diarylcarbamoyl and N-alkyl-N-arylcarbamoyl groups; the acyl group includes alkylcarbonyl and arylcarbonyl groups; the acyloxy group includes alkylcarbonyloxy groups; the oxycarbonyl group includes alkoxycarbonyl and aryloxycarbonyl groups; the halogen-substituted alkoxy group includes a-halogen-substituted alkoxy groups; the halogen-substituted aryloxy group includes tetrafluoroaryloxy and pentafluoroaryloxy groups; the pyrrolyl group includes 1-pyrrolyl group; and the tetrazolyl group includes 1-tetrazolyl group.

As the halogenated alkyl or aryl group there is suitably used a trifluoromethyl, heptafluoroisopropyl, nonylfluoro-t-butyl, tetrafluoroaryl or pentafluoroaryl group.

In Formula I, among the substituents represented by $R_1$ or $R_2$, those typically applicable other than electron-attractive groups having a σp of not less than 0.20 include alkyl, aryl, anilino, acylamino, sulfonamido, alkylthio, arylthio, alkenyl, cycloalkyl, cycloalkenyl, alkynyl, heterocyclic, alkoxy, aryloxy, heterocylic oxy, siloxy, amino, alkylamino, imido, ureido, sulfamoylamino, alkoxycarbonylamino, aryloxycarbonylamino, alkoxycarbonyl, aryloxycarbonyl, heterocyclic thio, thioureido, hydroxy and mercapto groups, spiro compound residues, and closslinked hydrocarbon compound residues.

The above alkyl group includes a straight-chained or branched alkyl group having preferably 1 to 32 carbon atoms. The above aryl group is preferably a phenyl group.

The above acylamino group includes alkylcarbonylamino and arylcarbonylamino groups: the sulfonamido group includes alkylsulfonylamino and arylsulfonylamino groups. The alkyl or aryl component of the above alkylthio or arylthio group corresponds to the above alkyl or aryl groups.

The alkenyl group may be either straight-chained or branched and includes those having 2 to 32 carbon atoms. The cycloalkyl group incudes those having preferably 3 to 12 carbon atoms, more preferably 5 to 7 carbon atoms. The cycloalkenyl group includes those having preferably 3 to 12 carbon atoms, more preferably 5 to 7 carbon atoms.

The ureido group includes alkylureido and arylureido groups; the sulfamoylamino group includes alkylsulfamoylamino and arylsulfamoylamino groups; the heterocyclic group is preferably a 5- to 7-member cyclic group such as 2-furyl, 2-thienyl, 2-pyrimidinyl and 2-benzothiazolyl groups; the heterocyclic oxy group is preferably one having a 5- to 7-member heterocyclic ring such as 3,4,5,6-tetrahydropyranyl-2-oxy and 1-phenyltetrazole-5-oxy groups; the heterocyclic thio group is preferably a 5- to 7-member heterocyclic thio group such as 2-pyridylthio, 2-benzothiazolylthio and 2,4-diphenoxy-1,3,5-triazole-6-thio groups; the siloxy group includes trimethylsiloxy, triethylsiloxy and dimethylbutylsiloxy groups; the imido group includes succinic acid imido, 3-heptadecylsuccinic acid imido, phthalimido and glutarimido groups; the spiro compound residue includes spiro[3.3]heptane-1-yl group; the closslinked hydrocarbon compound residue includes bicyclo[2.2.1]heptane-1-yl, tricyclo[3.3.1.$1^{3.7}$]decane-1-yl and 7,7-dimethyl-bicyclo[2.2.1]heptane-1-yl groups.

The above groups each may have a further substituent, a nondiffusible group such as a long-chain hydrocarbon group, or a polymer residue.

In Formula I, the group represented by $X_1$ capable of splitting upon reaction with an oxidation product of a color developing agent includes a halogen atom such as chlorine, bromine or fluorine, and alkoxy, aryloxy, heterocyclic oxy, acyloxy, sulfonyloxy, alkoxycarbonyloxy, aryloxycarbonyl, alkyloxalyloxy, alkoxyoxalyloxy, alkylthio, arylthio, heterocyclic thio, alkoxycarbonylthio, acylamino, sulfonamido, N atom-bonded nitrogen-containing heterocyclic, alkoxycarbonylamino, aryloxycarbonylamino and carboxyl groups. The preferred among these are a hydrogen atom and the alkoxy, aryloxy, alkylthio, arylthio, and N atom-bonded nitrogen-containing heterocyclic groups.

In Formula I, the nitrogen-containing 5-member heterocyclic ring formed with $Z_1$ includes pyrazole, imidazole, benzimidazole, triazole and tetrazole rings. The nitrogen-containing 5-member heterocyclic ring may form a condensate with a benzene ring.

To be concrete, the compounds represented by Formula I are represented by the following Formulas I-1 through I-7.

Formula I-1,

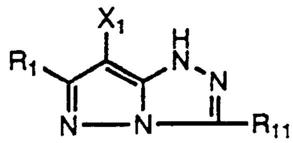

Formula I-5

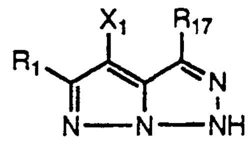

Formula I-2

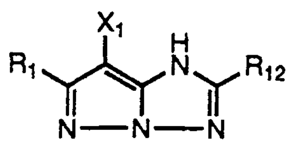

Formula I-6

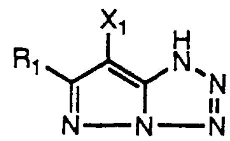

Formula I-3

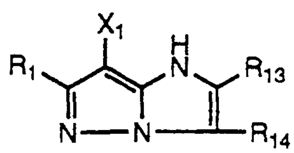

Formula I-7

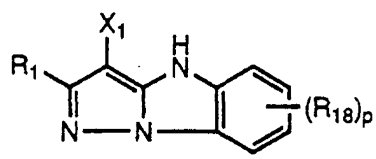

Formula I-4

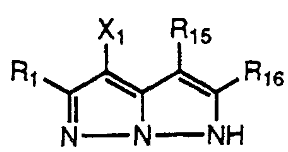

In the above Formulas, at least one of $R_1$ and $R_{11}$ of Formula I-1, at least one of $R_1$ and $R_{12}$ of Fomula I-2, at least one of $R_1$, $R_{13}$ and $R_{14}$ of Formula I-3, at least one of $R_1$, $R_{15}$ and $R_{16}$ of Formula I-4, at least one of $R_1$ and $R_{17}$ of Formula I-5, $R_1$ of Formula I-6, and at least one of $R_1$, $R_{18}$ of Formula I-7 represent an electron attractive group having a $\sigma p$ of not less than 0.20;

$X_1$ is as defined for the $X_1$ of Formula I; and p is an integer of 0 to 4.

In Formulas I-1 to I-7, of the groups represented by $R_1$ and $R_{11}$ to $R_{18}$ those other than the electron-attractive group having a σp of not less than 0.20 represent a hydrogen atom or a substituent having a σp of less than 0.20; of the groups represented by $R_{18}$ those having a $\sigma_p$ of less than 0.20 can be any groups without limit which, where the $R_1$ or $R_2$ in Formula I is one of those other than electron-attractive groups having a σp of not less than 0.20, include those described as the substituent represented by the $R_1$ or $R_2$ of Formula 1.

The cyan coupler having the electron attractive group useful in the invention can be easily synthesized according to appropriate one of the methods described in JP O.P.I. Nos. 554/1989, 555/1989, 556/1989, 557/1989, 552/1989, 105250/1989 and 105251/1989.

The coupler used in the invention can be used in an amount of $1x10^{-3}$ mol to 1 mol, and preferably $1x10^{-2}$ to $8x10^{-1}$ mol per mol of silver halide.

The coupler used in the invention may be used in combination with different other cyan couplers.

To the cyan coupler used in the invention those methods and techniques for ordinary cyan dye forming couplers may apply as well. Typically, the cyan coupler of the invention is incorporated into a silver halide emulsion, and the emulsion is coated on a support base to thereby form a color photographic light-sensitive material.

The cyan coupler represented by Formula II is explained.

The cyan coupler of Formula II is of a structure of a 6-member heterocyclic ring condensate with a pyrazole ring, wherein the substituent represented by $R_3$ can be any group with no restriction; examples of it include alkyl, aryl, anilino, acylamino, sulfonamido, alkylthio, arylthio, alkenyl and cycloalkyl groups, and further a halogen atom, and cycloalkenyl, alkynyl, heterocyclic, sulfonyl, sulfinyl, phosphonyl, acyl, carbamoyl, sulfamoyl, cyano, alkoxy, sulfonyloxy, aryloxy, heterocyclic oxy, siloxy, acyloxy, carbamoyloxy, amino, alkylamino, imido, ureido, sulfamoylamino, alkoxycarbonylamino, aryloxycarbonylamino, alkoxycarbonyl, aryloxycarbonyl, heterocyclic thio, thioureido, carboxyl, hydroxyl, mercapto, nitro and sulfo groups, and spiro compound residues and closslinked hydrocarbon compound residues.

The alkyl group represented by $R_3$ may be a straight-chained or branched alkyl group having preferably 1 to 32 carbon atoms. The aryl group is preferably a phenyl group.

The acylamino group represented by $R_3$ includes alkylcarbonylamino and arylcarbonylamino groups; the sulfonamido group includes alkylsulfonylamino and arylsulfonylamino groups. The alkyl and aryl components of the alkylthio group and the arylthio group are the same as those defined for the alkyl group and the aryl group, respectively, represented by the above $R_3$.

The alkenyl group represented by $R_3$ may be a straight-chained or branched alkenyl group having preferably 2 to 32 carbon atoms. The cycloalkyl group is preferably one having 3 to 12 carbon atoms, more preferably 5 to 7 carbon atoms. The cycloalkenyl group is preferably one having 3 to 12 carbon atoms, more preferably 5 to 7 carbon atoms.

The sulfonyl group represented by $R_3$ includes alkylsulfonyl and arylsulfonyl groups; the sulfinyl group includes alkylsulfinyl and arylsulfinyl groups; the phosphonyl group includes alkylphosphonyl, alkoxyphosphonyl, aryloxyphosphonyl and arylphosphonyl groups; the acyl group includes alkylcarbonyl and arylcarbonyl groups; the carbamoyl group includes alkylcarbamoyl and arylcarbamoyl groups; the sulfamoyl group includes alkyl sulfamoyl and arylsulfamoyl groups; the acyloxy group includes alkylcarbonyloxy and arylcarbonyloxy groups; the carbamoyloxy group includes alkylcarbamoyloxy and arylcarbamoyloxy groups; the ureido group includes alkyl ureido and arylureido groups; the sulfamoylamino group includes alkylsulfamoylamino and arylsulfamoylamino groups; the heterocyclic group is preferably 5-to 7-member one including 2-furyl, 2-thienyl, 2-pyrimidinyl, 2-benzothiazolyl, 1-pyrrolyl and 1-tetrazolyl groups; the heterocyclic oxy group is preferably one having a 5- to 7-member heterocyclic ring, such as 3,4,5,6-tetrahydropyranyl-2-oxy and 1-phenyltetrazole-5-oxy groups; the heterocyclic thio group is preferably a 5- to 7-member heterocyclic thio group such as 2-pyridylthio, 2-benzothiazolylthio and 2,4-diphenoxy-1,3,5-triazolo-6-thio groups; the siloxy group includes trimethylsiloxy, triethylsiloxy and dimethylbutylsiloxy groups; the imido group includes succinic acid imido, 3-heptadecylsuccinic acid imido, phthalimido and glutarimido groups; the spiro compound residue includes a spiro[3.3]heptane-1-yl group; the crosslinked hydrocarbon compound residue includes bicyclo[2.2.1]heptane-1-yl, tricyclo[3.3.1.1$^{3.7}$]decane-1-yl and 7,7-dimethyl-bicyclo[2.2.1]heptane-1-yl groups.

The above groups each may further have a substituent, a nondiffusible group such as a long-chain hydrocarbon group or a polymer residue.

The group represented by $X_2$ capable of splitting upon the reaction with an oxidation product of a color developing agent is the same group as defined for the $X_1$ of Formula I.

In Formula II, $Z_2$ represents a non-matallic atomic group necessary to form a 6-member nitrogen-containing heterocyclic ring including at least one carbonyl group, provided that the ring may have a substituent or condense with a benzene ring.

In Formula II, the 6-member nitrogen-containing heterocyclic ring formed with $Z_2$ is preferably of the 6π electron or 8π electron system having 1 to 4 nitrogen atoms including at least one -NH-, and at least one carbonyl group which the 6-member ring contains represents >C=O. The above 6-member nitrogen-containing heterocyclic ring may form a condensate with a benzene ring besides the foregoing pyrazole ring.

The compounds represented by Formula II include those represented by the following Formulas II-1 to II-6:

Formula II-1

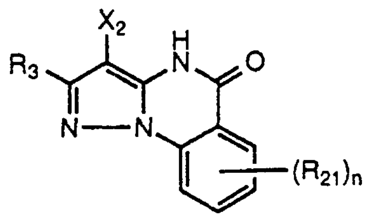

Formula II-4

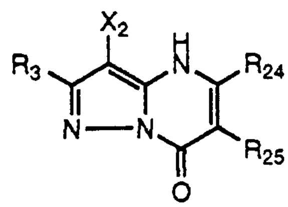

Formula II-2

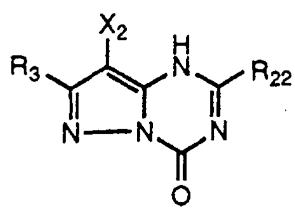

Formula II-5

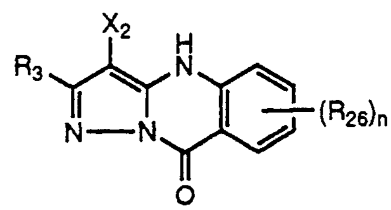

Formula II-3

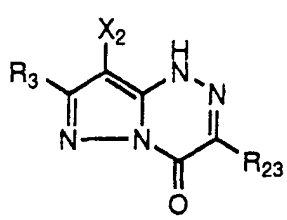

Formula II-6

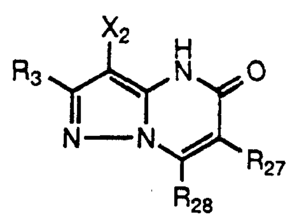

wherein $R_3$, $R_{21}$, $R_{22}$, $R_{23}$, $R_{24}$, $R_{25}$, $R_{26}$, $R_{27}$ and $R_{28}$ are as defined for the $R_1$ of Formula I; $X_2$ is as defined for the $X_1$ of Formula I. In Formulas II-1 and II-5, n is an integer of 0 to 4, provided that when n is an inter of 2 to 4, the plural number of $R_{21}$s and $R_{26}$s may be either the same or different, respectively.

In Formulas II-4 and II-6, $R_{24}$, $R_{25}$, $R_{27}$ and $R_{28}$ are as defined for the $R_1$ of Formula I, but $R_{24}$ and $R_{27}$ each can not be a hydroxyl group.

In Formula III, $R_4$ and $R_5$ each represent an electron attractive group having a Hammett's substituent constant ap of not less than 0.20, and the electron attractive group includes the same groups as those represented by the $R_1$ and $R_2$ of Formula I, provided that the sum of the σp values of $R_4$ and $R_5$ is-not less than 0.65. $X_3$ represents the same group as $X_1$ of Formula I.

The nitrogen-containing 5-member heterocyclic ring formed with $Z_3$ is a pyrazole ring, imidazole ring or tetrazole ring, which may have a substituent.

The compounds represented by Formula III are classified into those having the following Formulas III-1 to III-8:

Formula III-1

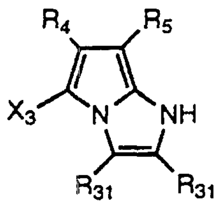

Formula III-5

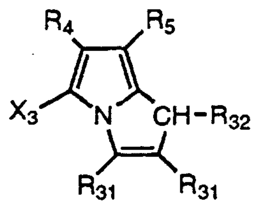

Formula III-2

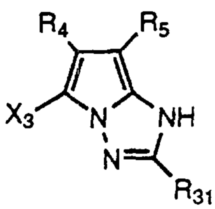

Formula III-6

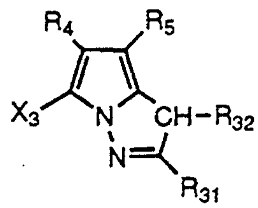

Formula III-3

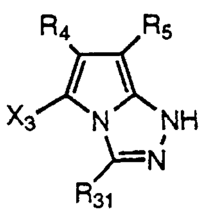

Formula III-7

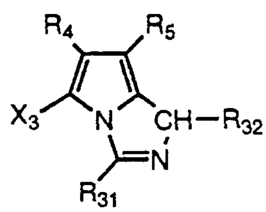

Formula III-4

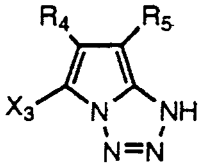

Formula III-8

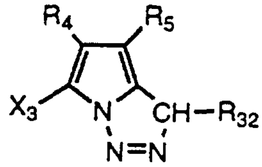

wherein $R_4$, $R_5$ and $X_3$ are as defined in Formula III; $R_{31}$ represents a hydrogen atom or a substituent; $R_{32}$ represents an electron attractive group having a Hammett's substituent constant σp of not less than 0.20.

The substituent represented by $R_{31}$ is as defined for the $R_3$ of Formula II; and the electron attractive group represented by $R_{32}$ is the same as those represented by the $R_1$ and $R_2$ of Formula I.

The preferred as the cyan coupler represented by Formula III are those represented by Formulas III-1, III-2 and III-3, and the most preferred is one having Formula III-2.

In Formula IV, $R_6$ and $R_7$ each represent a hydrogen atom or a substituent which is as defined for the $R_3$ of Formula II. In Formula IV, $X_4$ represents the same group as $X_1$ of Formula I.

In Formula IV, $Z_4$ represents a group of non-metallic atoms necessary to form a nitrogen-containing heterocyclic ring, provided the heterocyclic ring has at least one dissociation group. As the four divalent linkage groups for constituting the nitrogen-containing 6-member heterocyclic ring there are, e.g., -NH-, -N(R)-, -N=, -CH(R)-, -CH=, -C(R)=, -CO-, -SO- and -$SO_2$-, wherein R represents a substituent, whose examples include those represented by $R_{31}$. The dissociation group is one having acidic protons such as -NH-, -CH(R)-, preferably one having a pKa value of 3 to 12 in water. The above nitrogen-containing 6-member heterocyclic ring may have a substituent.

Suitable examples of the coupler represented by Formula IV include those having the following Formulas IV-1 to IV-6.

Formula IV-1

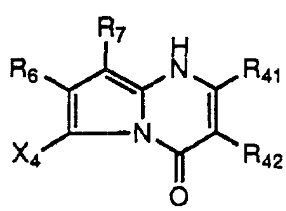

Formula IV-4

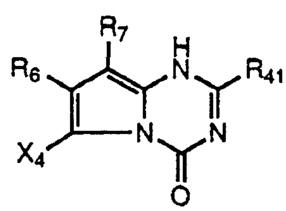

Formula IV-2

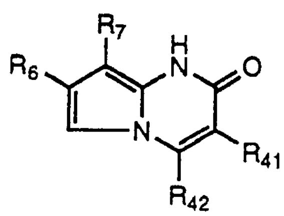

Formula IV-5

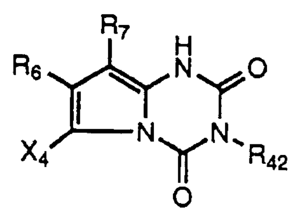

Formula IV-3

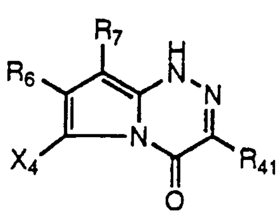

Formula IV-6

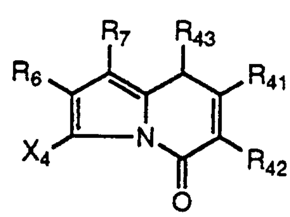

wherein $R_6$, $R_7$ and $X_4$ are as defined in Formula IV; $R_{41}$ and $R_{42}$ each represent a hydrogen atom or a substituent; and $R_{43}$ represents an electron attractive group having a Hammett's substituent constant σp of not less than 0.20; examples of the substituent represented by $R_{41}$ or $R_{42}$ are the same as those of the $R_3$ of Formula II, while examples of the electron attractive group represented by $R_{43}$ are the same as those of the $R_1$ and $R_2$ of Formula I.

Examples of the group represented by $X_4$ capable of splitting upon reaction with an oxidation product of a color developing agent are the same as those of the $X_1$ of Formula I.

The following are examples of the cyan coupler compounds represented by Formulas I through IV used in the invention, but the invention is not limited to the examples.

C−1

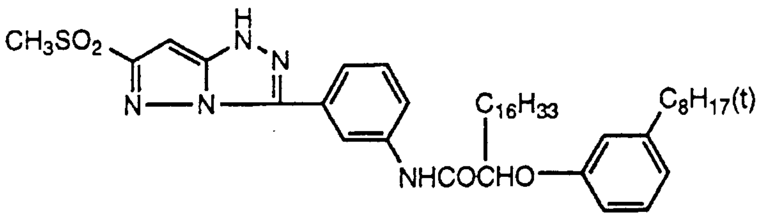

C−2

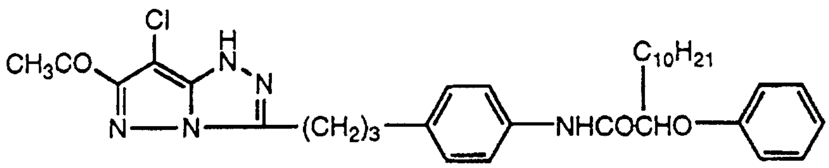

C−3

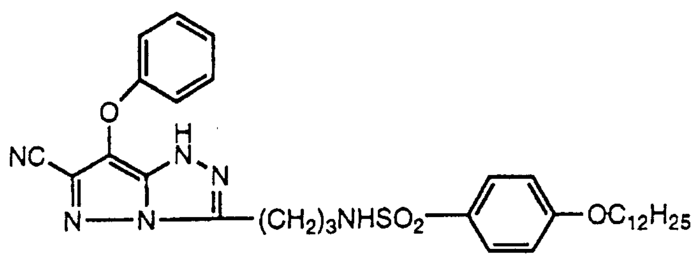

C−4

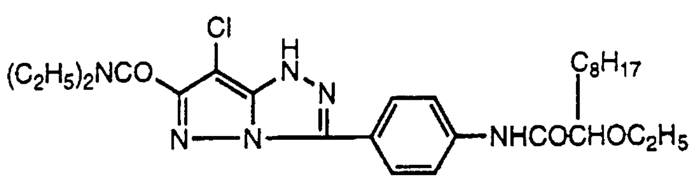

C−5

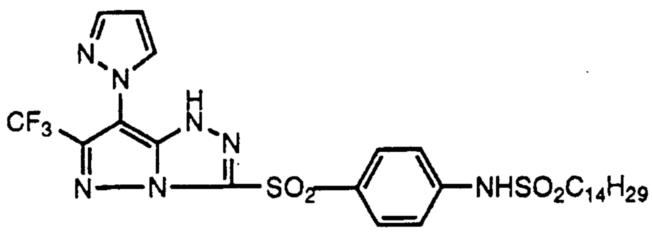

C−6

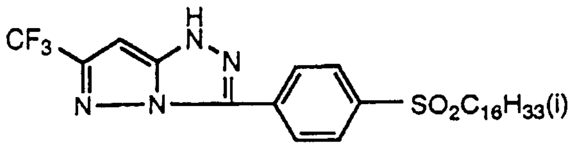

C−7

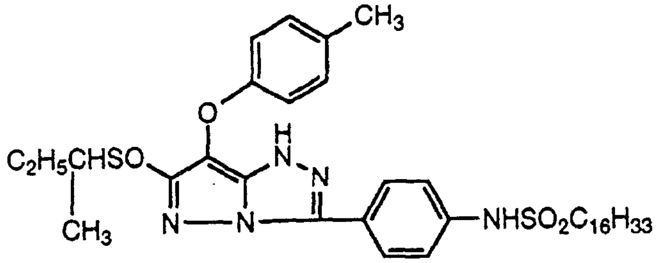

C−8

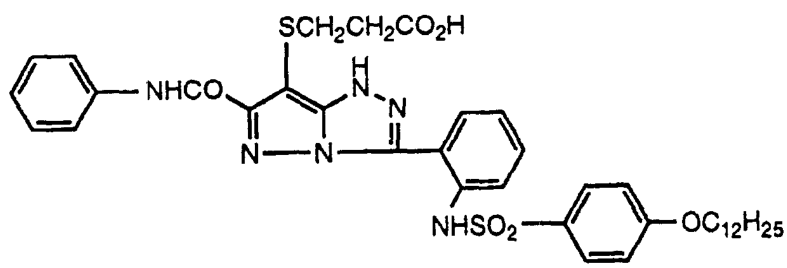

C−9

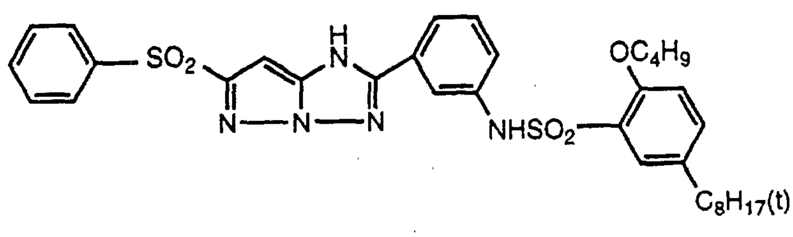

C−10

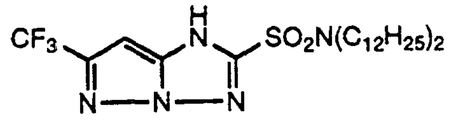

C−11

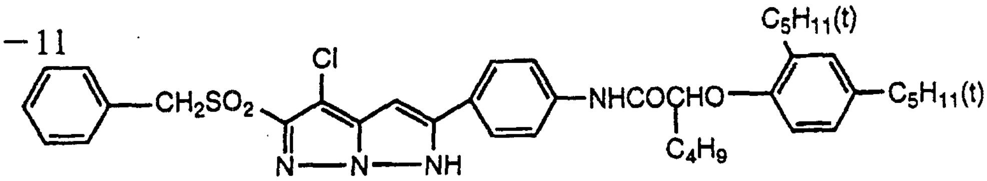

C−12

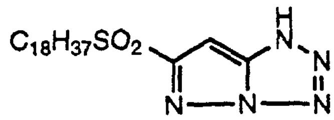

C−13

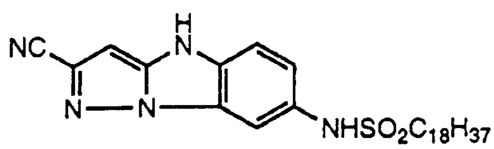

C−14

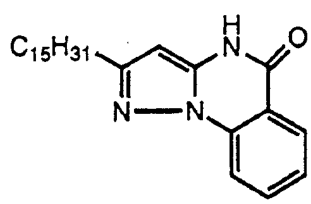

C−15

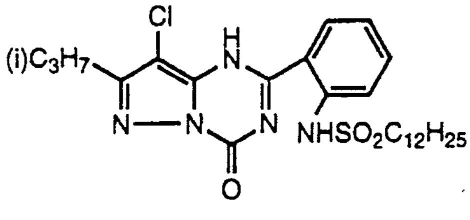

C−16

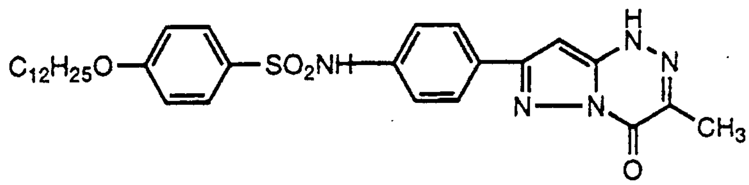

C−17

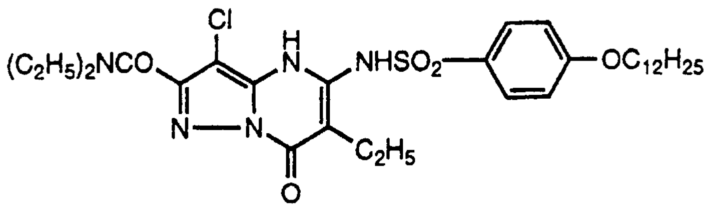

C−18

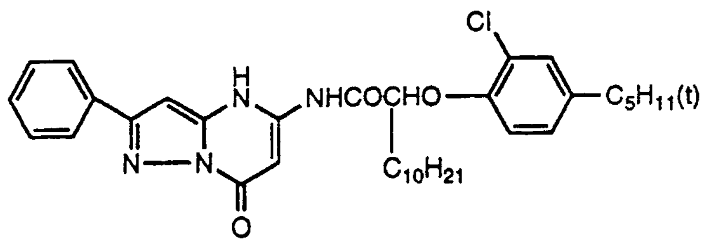

C−19

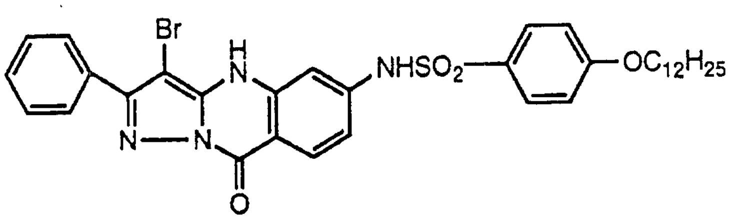

C−20

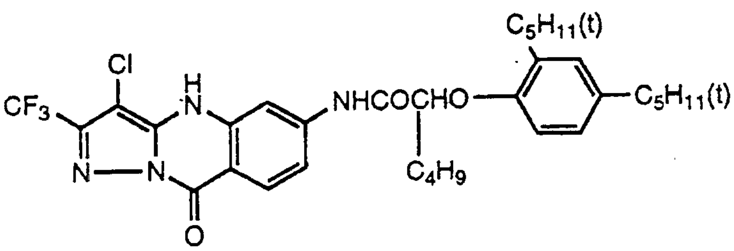

C-21

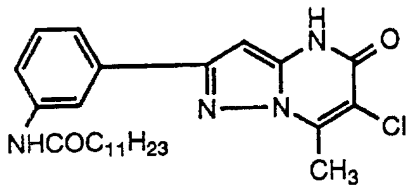

C-22

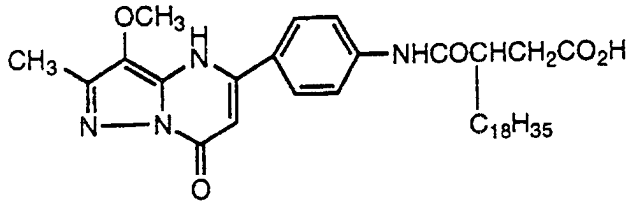

C-23

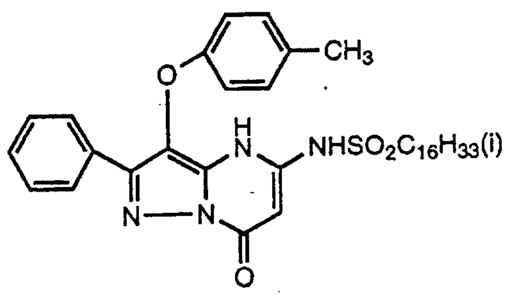

C-24

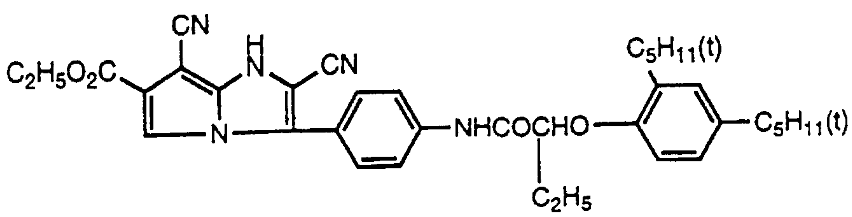

C-25

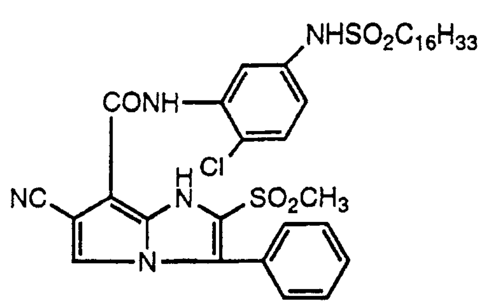

C-26

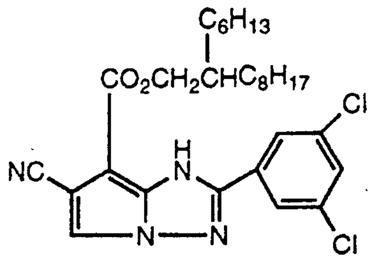

C-27

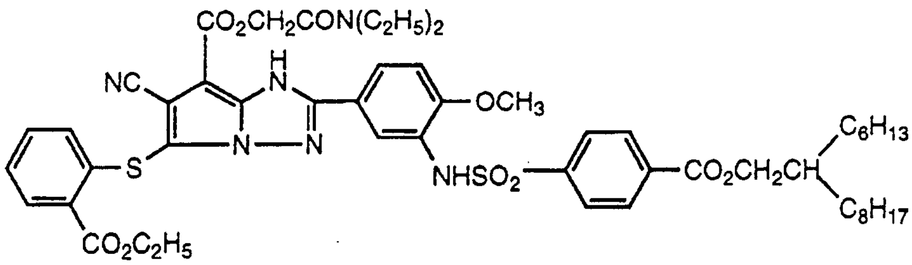

C-28

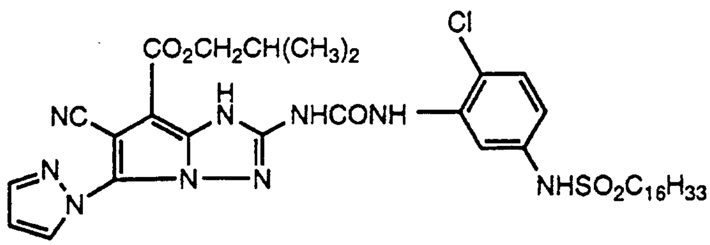

C-29

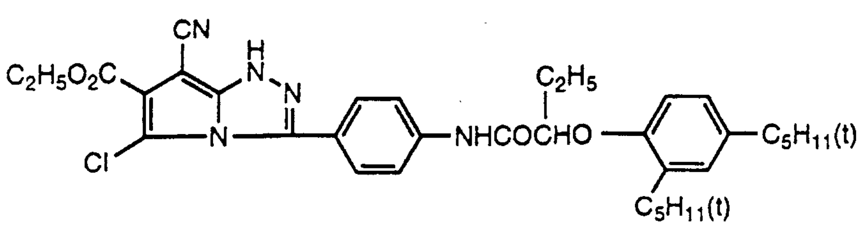

C−30

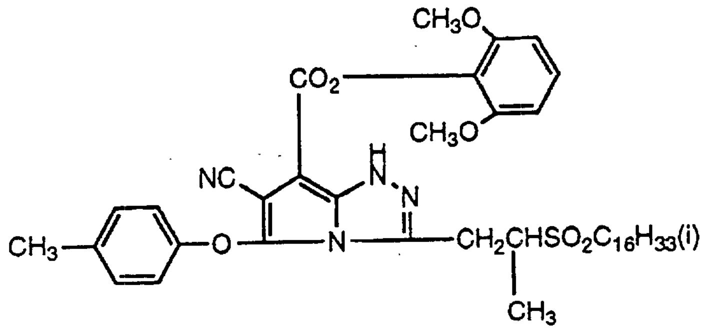

C−31

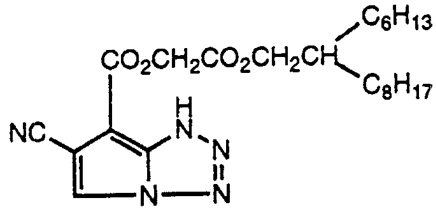

C−32

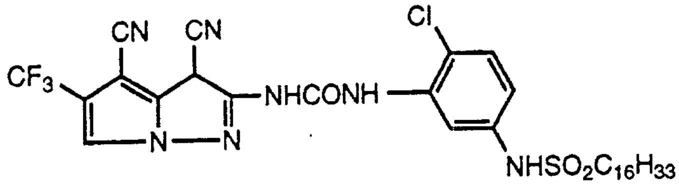

C−33

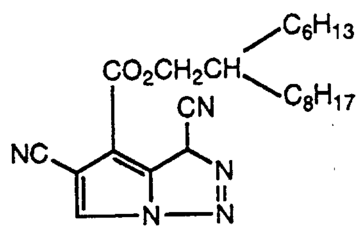

C−34

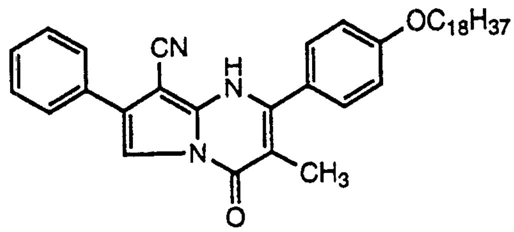

C−35

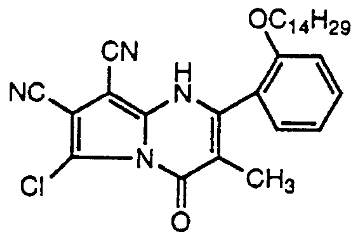

C−36

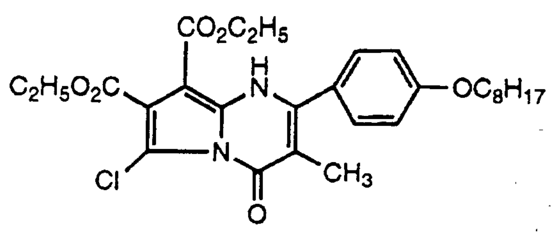

C−37

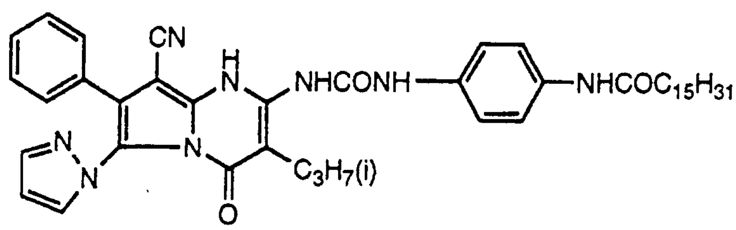

C−38

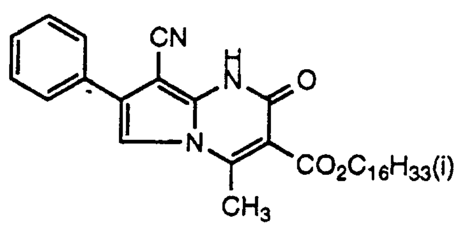

C−39

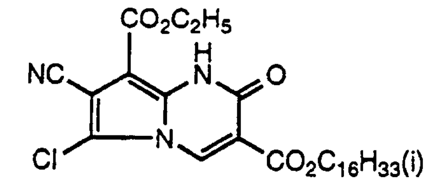

C−40

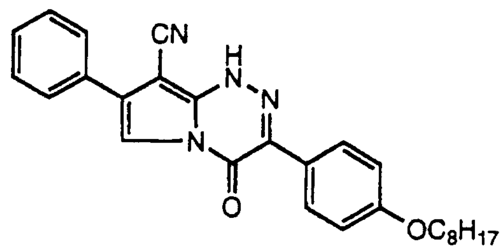

C−41

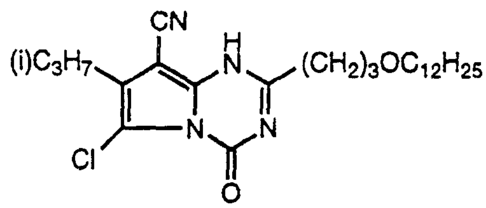

C−42

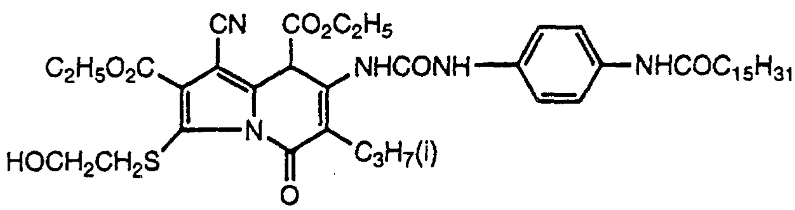

C−43

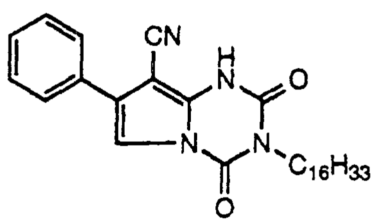

C−44

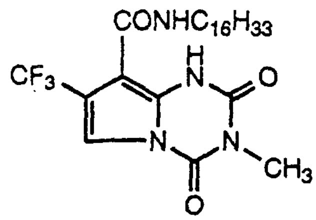

In the silver halide color photographic light-sensitive material of the invention, its yellow image forming silver halide emulsion layer, magenta image forming silver halide emulsion layer and cyan image forming silver halide emulsion layer comprise their respective silver halide emulsions having their own spectral sensitivity wavelength regions different from one another, and at least one of the above yellow, magenta and cyan image forming silver halide emulsion layers contains another silver halide emulsion whose spectral sensitivity is partially common to those of the emulsions having their respective spectral sensitivity regions different from one another contained in the above yellow, magenta and cyan image-forming silver halide emulsion layers.
In the invention, the yellow image forming layer, magenta image forming layer and cyan image forming layer are different from one another in the spectral sensitivity. In the wavelength region of the spectral sensitivity of one layer, the layer needs to have a certain wavelength at which the layer can show a spectral sensitivity which is preferably at least 4 times, more preferably at least 8 times higher than that of another layer.
In the invention, the silver halide emulsion with a spectral sensitivity wavelength having a portion common to all of the emulsions having their respective spectral sensitivity wavelength regions different from one another contained in the yellow, magenta and cyan image forming silver halide emulsion layers is explained. In order to simplify the explanation, of the above silver halide emulsions having different spectral sensitivities, the silver halide emulsion contained in the yellow image forming layer is hereinafter referred to as Emulsion Y, that contained in the magenta image forming layer as Emulsion M, and that in the cyan image forming layer as Emulsion C. Further, the silver halide emulsion with a spectral sensitivity wavelength having a portion common to all of the emulsions having different spectral sensitivities contained in the yellow, magenta and cyan image forming silver halide emulsions is hereinafter called Emulsion P. In the invention, Emulsion P has a spectral sensitivity region which is partially in common to the spectral sensitivity region of Emulsion Y; has a further spectral sensitivity region partially in common to the spectral sensitivity region of Emulsion M; and has a still further spectral sensitivity partially common to the spectral sensitivity region of Emulsion C.
The ratio of the sensitivity of Emulsions P to that of Emulsion Y when exposed to a light at a certain wavelength within the spectral sensitivity region of Emulsion Y is preferably in the range of 1/10 to 10. Similarly, the ratio of the sensitivity of Emulsions P to that of Emulsion M when exposed to a light at a certain wavelength within the spectral sensitivity region of Emulsion M is preferably in the range of 1/10 to 10. And similarly, the ratio of the sensitivity of Emulsions P to that of Emulsion C when exposed to a light at a certain wavelength within the spectral sensitivity region of Emulsion C is preferably in the range of 1/10 to 10.
In a preferred example in accordance with the invention, the yellow image forming layer contains a blue-sensitive silver halide emulsion, the magenta image forming layer contains a green-sensitive silver halide emulsion, and the cyan image forming layer contains a red-sensitive silver halide emulsion. The above yellow image forming emulsion layer further contains a silver halide emulsion sensitive to all of blue, green and red rays. The above magenta image forming emulsion layer and the cyan image forming emulsion layer each also further contain a silver halide emulsion sensitive to all of blue, green and red rays.
In another preferred example in accordance with the invention, the yellow image forming layer contains a green-sensitive silver halide emulsion, the magenta image forming layer contains a red-sensitive silver halide emulsion, and the cyan image forming layer contains an infrared-sensitive silver halide emulsion. The above yellow image forming layer further contains a silver halide emulsion sensitive to all of green, red and infrared rays. And, the above magenta and cyan image forming emulsion layers each also further contain a silver halide emulsion sensitive to all of green, red and infrared rays.
In a further preferred example in accordance with the invention, the yellow image forming layer contains a blue-sensitive silver halide emulsion, the magenta image forming layer contains a green-sensitive silver halide emulsion, and the cyan image forming layer contains a red-sensitive silver halide emulsion, wherein the yellow image forming layer and the cyan image forming layer further contain a silver halide emulsion sensitive to all of blue, green and red rays.
In addition to the above combinations, it is possible to freely select the color sensitivities of Emulsions Y, M

and C, and as long as their color sensitivities are different from one another there can be made any combinations. Emulsion P need only be contained in at least one of the yellow, magenta and cyan layers.

The silver halide emulsion (Emulsion P) having a spectral sensitivity partially common to all the spectral sensitivities of the yellow, magenta and cyan image forming silver halide emulsions can be realized by the use of appropriately selected spectral sensitizing dyes. For example, the emulsion sensitive to all of blue, green and red rays can be produced by the combined use of blue-sensitizing dyes, green-sensitizing dyes and red-sensitizing dyes.

The silver halide grain diameter of the respective emulsion layers of the silver halide photographic light-sensitive material of the invention can be determined according to the characteristics required therefor, particularly taking into account various characteristics such as the sensitivity, sensitivity balance, color separation, sharpness and graininess.

In a preferred embodiment of the invention, the silver halide grain diameter is preferably 0.1μm to 0.6μm for the emulsion of the red-sensitive layer, preferably 0.15μm to 0.8μm for the emulsion of the green-sensitive layer, and preferably 0.3μm to 1.2μm for the emulsion of the blue-sensitive layer.

The average grain diameter of the aforementioned Emulsion P used in the invention, although not restricted, preferably has a proportion of 0.4 to 3.0, more preferably 0.7 to 2.0 to the largest average diameter of Emulsions Y, M and C.

In the invention, it is preferable to provide another image forming layer in addition to the yellow image forming silver halide emulsion layer, magenta image forming silver halide emulsion layer and cyan image forming silver halide emulsion layer. In order to simplify the explanation, this layer is hereinafter referred to as an auxiliary image layer. In the invention, the auxiliary image layer is a silver halide emulsion layer capable of forming at least an image that absorbs a red light.

The auxiliary image layer contains silver halide, and it may have a spectral sensitivity in a region different from the region to which the spectral sensitivities of the yellow, magenta and cyan layers belong, or may have a spectral sensitivity having a portion common to the spectral sensitivities distribution of the yellow, magenta and cyan image layers. For example, in the case where the yellow image layer is blue-sensitive, the magenta image layer is green-sensitive and the cyan image layer is red-sensitive, it is preferable for the auxiliary image layer to comprise a silver halide having a spectral sensitivity to all of blue, green and red rays. Still another preferred embodiment of the invention is such that where the yellow image layer is blue-sensitive, the magenta image layer is green-sensitive and the cyan image layer is red-sensitive, the auxiliary image layer can be infrared-sensitive. Besides these embodiments there may be arbitrarily selected various other combinations of color sensitivities.

In order to provide the above-mentioned spectral sensitivities, any conventionally known arbitrary sensitizing dyes and known combinations of them may be used.

The auxiliary image layer used in the invention forms at least an image that absorbs a red light. The auxiliary image layer of the invention refers to a layer capable of forming an image having a density of 0.1 to 1.6 to a red light having a wavelength of 620 to 680nm. The absorption of a light other than the red light is discretionary, but in one preferred embodiment, the auxiliary image layer forms an image that absorbs blue and green lights. In another preferred embodiment, the auxiliary image layer forms an image that absorbs a blue light as well as a red light. In still another example of the embodiment, the auxiliary image layer forms a neutral black image.

For the image formation of the auxiliary image layer, a conventionally known cyan coupler may be incorporated into the layer. A conventionally known black coupler for the formation of a black image may also be incorporated. Further, yellow, magenta and cyan couplers may be mixedly used with these couplers. A silver image may also be used as the image of the auxiliary image layer.

The auxiliary image layer used in the invention may be provided in any arbitrary position inside the light-sensitive material; it may be located either nearest to or furthest from the support.

In the invention, a hydrophilic colloid layer containing a white pigment may be used as a light-reflection layer. In this instance, the white pigment is used in an amount of preferably 20 to 80% by weight, more preferably 30% to 70% by weight to the binder coating weight of the light reflection layer.

As the white pigment there may be used an inorganic and/or an organic white pigment, preferably an inorganic white pigment. Examples of the white pigment include sulfates of alkaline earth metals such as barium sulfate, carbonates of alkaline earth metals such as calcium carbonate, powdery silicic acid, synthetic silicates, calcium silicate, alumina, alumina hydrate, titanium oxide, zinc oxide, talc, and clay.

The suitable among them are preferably barium sulfate, calcium carbonate and titanium oxide, more preferably barium sulfate and titanium oxide.

The titanium oxide used may be of either the rutile type or the anatase type, and may also be one having its surface coated with a metal oxide such as water-containing alumina oxide or water-containing ferrite oxide.

The above white pigment may be used in combination with additives such as a colored pigment, a brightening agent, and an antioxidant.

The coating weight of the white pigment is in the range of preferably 1 to 50g/$m^2$, and more preferably 2 to

20g/m$^2$.

The suitable as the magenta coupler in the invention are those compounds represented by the following Formula M-I:

Formula M-I

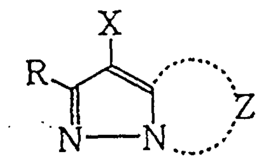

wherein

Z represents a group of non-metallic atoms necessary to form a nitrogen-containing heterocyclic ring which may have a substituent;
X is a hydrogen atom or a group capable of splitting upon reaction with an oxidation product of a color developing agent;and
R is a hydrogen atom or a substituent.

In Formula M-I, the substituent represented by R can be any arbitrary group without limit, typical examples of which include alkyl, aryl, anilino, acylamino, sulfonamido, alkylthio, arylthio, alkenyl and cycloalkyl groups, and also include halogen atoms, cycloalkenyl, alkynyl, heterocyclic, sulfonyl, sulfinyl, phosphonyl, acyl, carbamoyl, sulfamoyl, cyano, alkoxy, aryloxy, heterocyclic oxy, siloxy, acyloxy, carbamoyloxy, amino, alkylamino, imido, ureido, sulfamoylamino, alkoxycarbonylamino, aryloxycarbonylamino, alkoxycarbonyl, aryloxycarbonyl and heterocyclic thio groups, and further spirocompound residues and crosslinked hydrocarbon compound residues,

The preferred extents and examples of the substituent represented by R, of the group represented by X which is capable of splitting upon the reaction with the oxidation product of a color developing agent, of the nitrogen-containing heterocyclic ring formed with Z, and of the substituent which the ring formed with Z may have, and suitable examples of the magenta couplers represented by Formula M-I are the same as those described in European Patent No. 0327272, p.5, line 23 to p.8, line 52.

The following are typical examples of the magenta coupler represented by Formula M-I:

M - 1

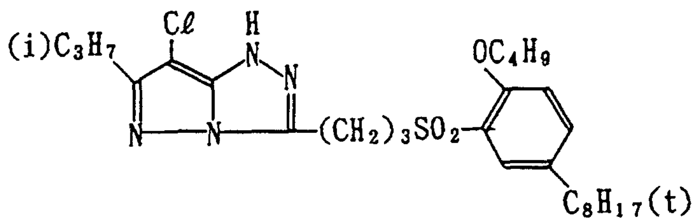

M - 2

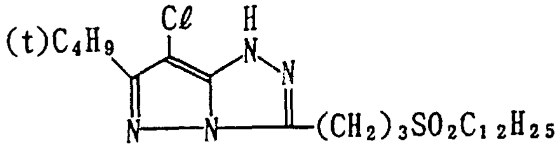

M − 3

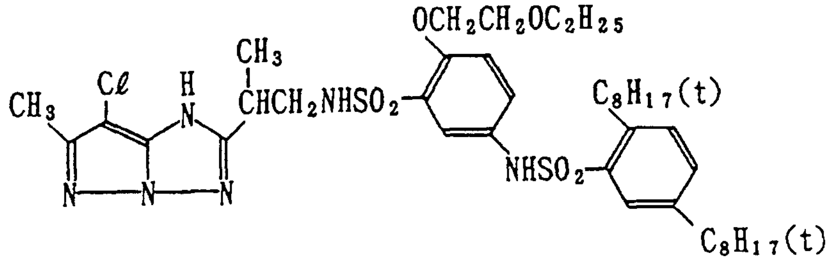

M − 4

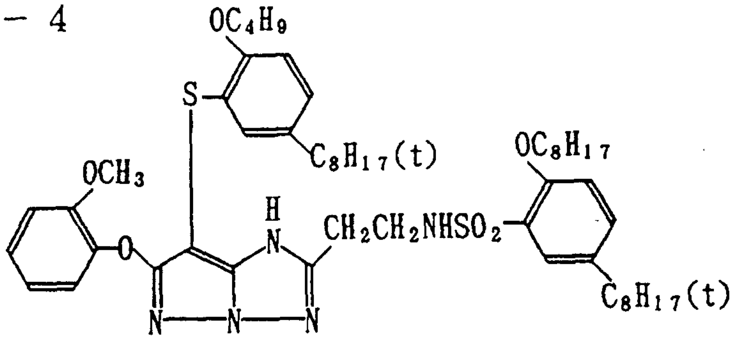

M − 5

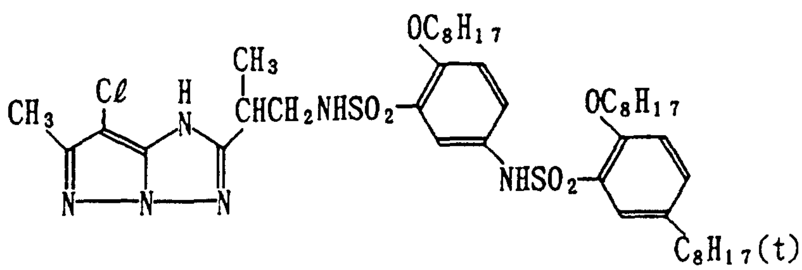

M − 6

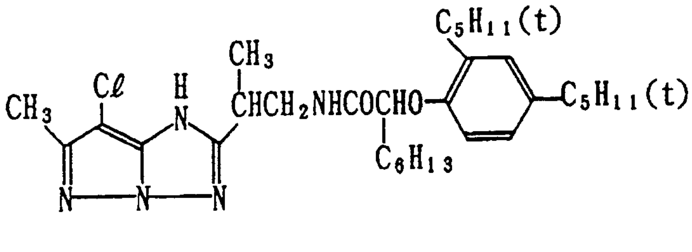

M − 7

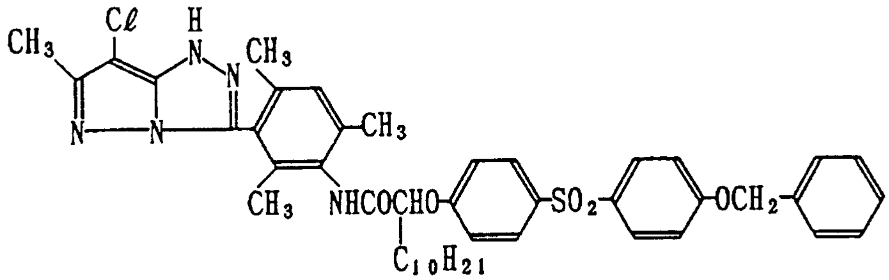

M − 8

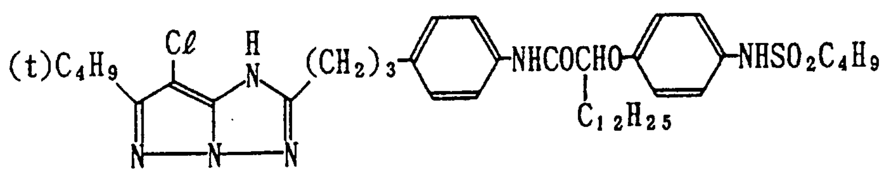

M − 9

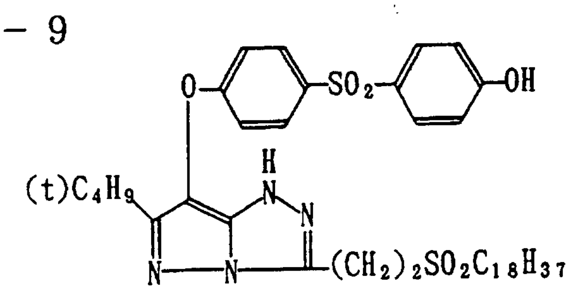

M − 10

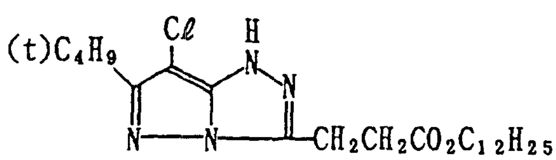

M − 11

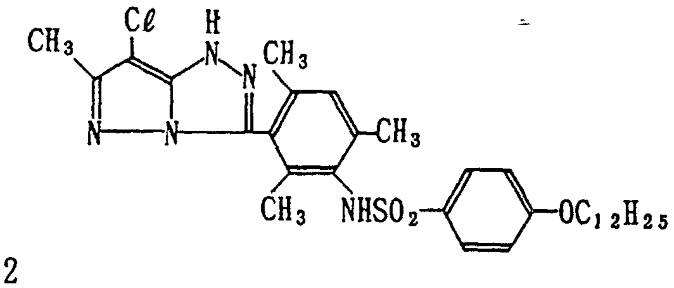

M − 12

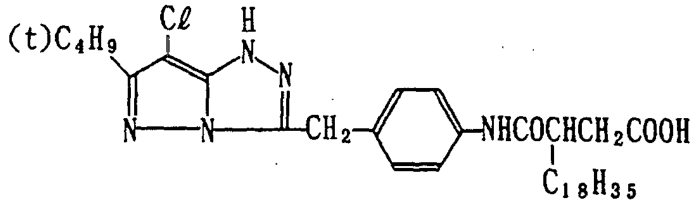

M − 13

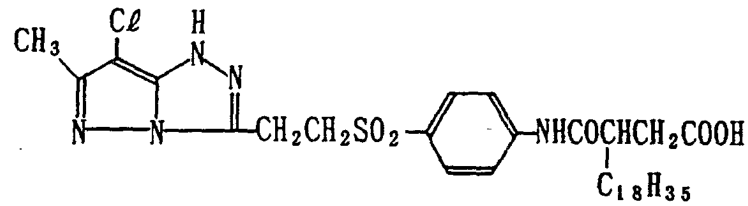

M − 14

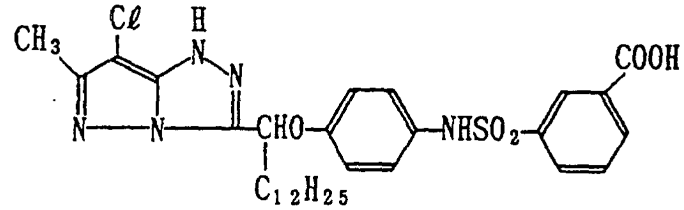

M − 15

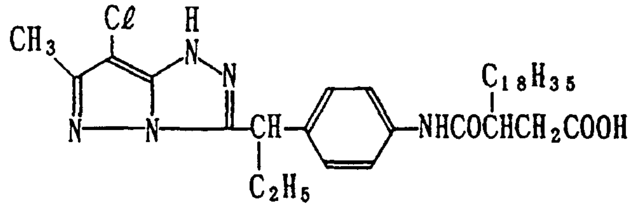

M - 16

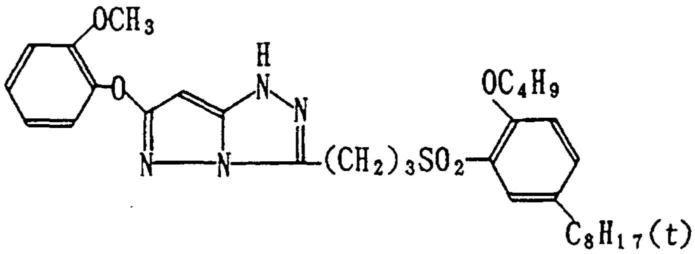

M - 17

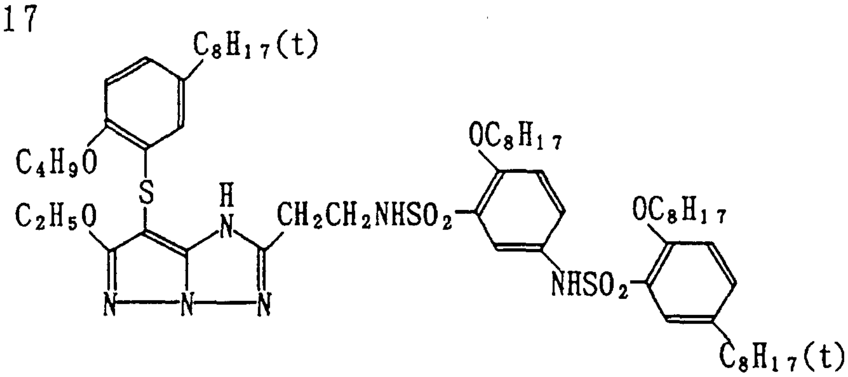

M - 18

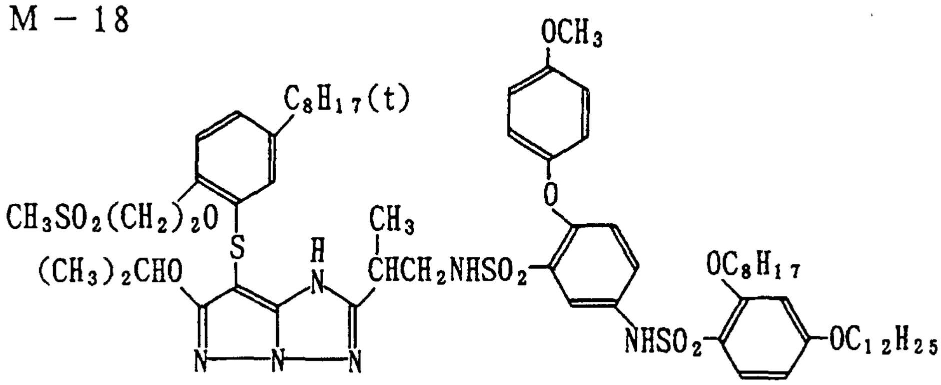

M - 19

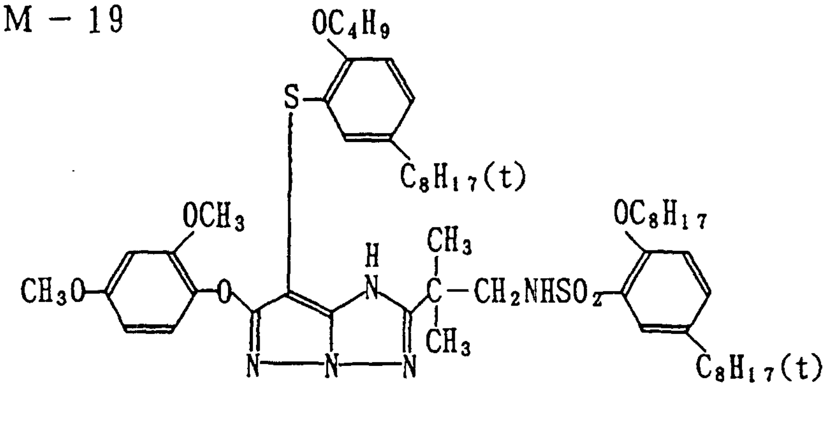

Further examples other than the above compounds include the compounds M-1 to M-61 described in European O.P.I. Patent No. 0273712, pp.6-21 and the compounds 1 to 223 described in European Patent No. 0235913,

pp.36-92.

Any of the above couplers can be synthesized by making reference to Perkin, the 'Journal of the Chemical Society,' pp.2047-2052 (1977); U.S. Patent No. 3,725,067; JP O.P.I. Nos. 99437/1984, 42045/1983, 162548/1984, 171956/1984, 33552/1985, 43659/1985, 172982/1985, 190779/1985, 209457/1987 and 307453/1988.

Any of the above couplers may be used in combination with different other magenta couplers. The above coupler may be used in the amount range of preferably $1x10^{-3}$ mol to 1 mol, more preferably $1x10^{-2}$ mol to $8x10^{-1}$ mol per mol of silver halide.

The magenta image formed with the color photographic light-sensitive material of the invention preferably has a spectral absorption $\lambda_{L0.2}$ of 580 to 635nm.

The maximum spectral absorption λmax of the magenta image having a spectral absorption $\lambda_{L0.2}$ of 582 to 635nm in the silver halide color photographic light-sensitive material is preferably 530 to 560nm.

The $\lambda_{L0.2}$ and λmax of the spectral absorption of the magenta image formed with the silver halide color photographic light-sensitive material in the invention are values measured in the following procedure:

($\lambda_{L0.2}$ and λmax measurements)

The silver halide color photographic light-sensitive material, in the case of the positive type, is uniformly exposed to a red light in the minimum exposure amount to give the minimum cyan image density and uniformly exposed to a blue light in the minimum exposure amount to give the minimum yellow image density, exposed through an ND filter to a white light and then processed to thereby form a magenta image. In this instance, the magenta image is formed by adjusting the ND filter's density to give 1.0 of the maximum value of the absorbance when the 500 to 700nm spectral absorption is measured with a spectrophotometer equipped with an integrating sphere and a magnesium oxide reference white plate for zero-point correction.

Where the silver halide color photographic light-sensitive material is of the negative type, when it is exposed through an ND filter to a green light and processed to form a magenta image, the ND filter's density is adjusted in the same manner as in the above positive so as to obtain the maximum absorbance. The $\lambda_{L0.2}$ refers to a wavelength at which the magenta image shows an absorbance of 0.2 and which is longer than the wavelength at which the magenta image shows the maximum absorbance of 1.0 on the spectral absorbance curve.

As the silver halide emulsion used in the invention there may be used a surface latent image-type silver halide emulsion that is imagewise exposed to form a latent image on its surface, and processed to thereby form a negative image. And there is preferably used an internal latent image-type silver halide emulsion having its grain surface previously unfogged which, after being imagewise exposed, is subjected to fogging treatment (nucleus-making treatment) followed by surface development or which, after being imagewise exposed, is subjected to surface development while being subjected to fogging treatment to thereby obtain a direct positive image.

The above fogging treatment may be achieved by having the emulsion overall exposed to light, chemically fogged with a fogging agent, processed in a strong developer solution or subjected to heat treatment. The aforementioned internal latent image-type silver halide grains-containing emulsion is an emulsion containing silver halide crystal grains each having a sensitivity speck mainly thereinside to form an internal latent image when exposed to light.

In the technological field of the internal latent image-type direct positive emulsion, there have been known to date various techniques such as, for example, those described in U.S. Patent Nos. 2,592,250, 2,466,957, 2,497,875, 2,588,982, 3,761,266, 3,761,276 and 3,796,577; and British Patent No. 1,151,363.

The positive image forming mechanism is not entirely clear. However, the 'Photographic Science and Engineering,' vol.20, p.158 91976) describes about the mechanism as follows:

The photoelectrons produced inside a silver halide crystal grain by imagewise exposure are selectively captured inside the grain to thereby form an internal latent image. The internal latent image acts as an effective capture center to the electrons in the conduction band, so that in an exposed grain, the electrons poured in the subsequent fogging/developing process are to be captured inside the grain to thereby intensify the latent image. In this instance, the latent image rests so deep inside the grain that it is not developed by surface development. On the other hand, in a grain not imagewise exposed, at least part of the electrons are captured to the grain surface to thereby form a latent image thereon, so that the grain is developed by surface development.

The previously unfogged internal image-type silver halide emulsion usable in the invention is an emulsion containing silver halide grains each forming a latent image mainly thereinside and having most of sensitivity specks thereinside, and it includes silver bromide, silver chloride, silver chlorobromide, silver chloroiodide, silver iodobromide, and silver chloroiodobromide.

The above emulsion is most preferably one which is such that when it is coated on a support so that its silver coating weight is in the range of 1 to $3.5g/m^2$ to prepare a sample, and when one partial piece of the prepared sample is subjected to light intensity scale exposure for specified periods of time ranging from 0.1 to 1.0 second and developed at 20°C for 4 minutes in the following surface developer solution A substantially not containing any silver halide solvent for developing the surface image alone of the grain, the maximum density of the thus processed piece is not more than 1/5 of the maximum density of the other part of the same sample that is obtained by being exposed likewise and

developed at 20°C for 4 minutes in the following internal developer B capable of developing the latent image inside the grain.

| Surface developer solution A | |
|---|---|
| Metol | 2.5 g |
| L-ascorbic acid | 10.0 g |
| Sodium metaborat (tetrahydrate) | 35.0 g |
| Potassium bromide | 1.0 g |
| Water to make | 1000 ml |

| Internal developer solution B | |
|---|---|
| Metol | 2.0 g |
| Anhydrous sodium sulfite | 90.0 g |
| Hydroquinone | 8.0 g |
| Sodium carbonate (monohydrate) | 52.5 g |
| Potassium bromide | 5.0 g |
| Potassium iodide | 0.5 g |
| Water to make | 1000 ml |

The internal latent image-type silver halide emulsion suitably usable in the invention include those prepared in various methods, such as the conversion-type silver halide emulsion described in U.S. Patent No. 2,592,250; the silver halide emulsion comprising internally chemically sensitized silver halide grains described in U.S. Patent Nos. 3,206,316, 3,317,322 and 3,367,778; the emulsion containing polyvalent metallic ion-incorporated silver halide grains described in U.S. Patent Nos. 3,271,157 and 3,447,927; the silver halide emulsion comprising weakly chemically sensitized silver halide grains containing a doping agent described in U.S. Patent No. 3,761,276; the silver halide emulsion comprising grains having multiphase structure described in JP O.P.I. Nos. 8524/1975, 38525/1975 and 2408/1978; and the silver halide emulsion described in JP O.P.I. Nos. 156614/1977 and 127549/1980.

The internal latent image-type silver halide grain usable in the invention may be of any arbitrary silver halide such as silver bromide, silver chloride, silver chlorobromide, silver chloroiodide, silver iodobromide or silver chloroiodobromide. The silver chloride grains are excellent in the developability and suitable for rapid processing.

The silver halide crystal grains used in the invention may have any form such as a cubic form, an octahedral form, a tetradecahedral form comprised of a mixture of (100) and (111) planes, a form having (110) planes, a spherical form or a tabular form. Suitably usable silver halide grains are ones having an average grain diameter of 0.05 to 3μm. The silver halide emulsion used in the invention may be either a monodisperse emulsion comprising grains having uniform grain diameters or uniform crystal habits or a polydisperse emulsion comprising grains whose grain diameters or crystals habits are not uniform. In the invention, the monodisperse silver halide emulsion is one in which the weight of the silver halide grains having grain diameters within the limits of its average diamter r ±20% accounts for preferably not less than 60%, more preferably not less than 70%, and most preferably not less than 80% of the total weight of the whole silver halide grains thereof. The average grain diameter r herein is defined as the grain diameter ri in the case where the product of frequency ni of the grain having a grain diameter ri and $ri^3$, i.e., ni x $ri^3$, comes to the maximum (round to three decimal places), wherein the grain diameter, in the case of a spherical silver halide grain, is the diameter itself, while in the case of a nonspherical grain, is the diameter of a circular image equivalent in the area to the projection image of the grain. The grain diameter can be obtained by a method in which the grain is electron-microphotographically 10,000-fold to 50,000-fold enlarged, and the diameter of the enlarged grain image on its photo print or the area of the projection grain image enlarged likewise is actually measured. (The number of grains for measurement shall be 1000 or more at random.)

The most preferred highly monodisperse emulsion is of silver halide grains having a grain diameter distribution broadness of not more than 20%, said distribution broadness being defined by:

$$\frac{\text{Grain diameters standard deviation}}{\text{Average grain diameter}} \times 100 = \text{distribution broadness (\%)}$$

wherein the above average grain diameter and the grain diameters standard deviation are to be found from the earlier defined ri.

The monodisperse emulsion can be obtained by adding an aqueous silver salt solution and an aqueous halide solution under controlled pAg and pH conditions according to a double-jet precipitation method. For determination of the adding rate, reference can be made to JP O.P.I. Nos. 48521/1979 and 49938/1983.

To obtain a highly monodisperse emulsion there can be used the method for growing the grain in the presence of a tetrazaindene compound disclosed in JP O.P.I. No. 122935/1985.

The fogging treatment in the internal latent image-type direct positive image formation suitably applicable to the invention can be effected by giving an overall exposure or by using a compound capable of forming a fog speck, i.e., a fogging agent.

The overall exposure is made in the manner that an imagewise exposed light-sensitive material, after being immersed in a developer solution or other aqueous solution or moistened by any arbitrary means, is uniformly overall exposed to light. The light source to be used in this instance is allowed to be of any kind as long as it emits a light belonging to the spectral wavelength region to which the above light-sensitive material is sensitive, said light including a flash light for high-intensity/short-time exposure and a weak light for long-time exposure. The overall exposure time may be varied according to the photographic light-sensitive material used, the processing conditions, the type of the light source used, and the like, so as to be able to finally obtain the best positive image. For the overall exposure it is most preferable for the light-sensitive material to use an exposure amount within certain specified limits. Normally, the use of an over exposure amount brings about a rise of the minimum density or desensitization of the light-sensitive material, resulting in image quality degradation.

The fogging agent suitably usable in the invention is explained.

The fogging agent used in the invention includes diverse compounds. The fogging agent need only be present at the time of developing; for example, it may be present in the non-support component layer, preferably in the silver halide emulsion layer, of the photographic light-sensitive material, or alternatively in a developer bath or in a processing solution prior to the developer bath. The using amount of the fogging agent necessary when adding it to the silver halide emulsion layer is preferably 1 to 1,500mg, more preferably 10 to 1,000mg per mol of silver halide, while when adding it to a processing solution such as a developer solution, the amount is preferably 0.01 to 5g/liter, and most preferably 0.05 to 1g/liter.

Examples of the fogging agent include compounds having groups adsorbable to the surface of silver halide such as the hydrazines described in U.S. Patent Nos. 2,563,785 and 2,588,982; the hydrazide and hydrazine compounds described in U.S. Patent No. 3,227,552; the heterocyclic quaternary nitrogen-containing compounds; and the acylhydrazinophenylthioureas described in U.S. Patent No. 4,030,925. These fogging agents may be used in combination. For example, Research Disclosure 15162 describes the combination of a nonadsorption-type fogging agent with an adsorption-type fogging agent, and the technique of this combination is effective also in the invention. The fogging agent used in the invention may be either of the adsorption type or of the nonadsorption type, and may be used in combination of these compounds of both types.

Useful examples of the fogging agent include hydrazine compounds such as hydrazine hydrochloride, 4-methylphenylhydrazine hydrochloride, 1-acetyl-2-phenylhydrazine, 1-formyl-2-(4-methylphenyl)hydrazine, 1-methylsulfonyl-2-phenylhydrazine, 1-methylsulfonyl-2-(3-phenylsulfonamidophenyl)hydrazine, 1-benzoyl-2-phenylhydrazine and formaldehydophenylhydrazine; N-substituted quaternary cycloammonium salts such as 3-(2-formylethyl)-2-methylbenzothiazolium bromide, 3-(2-acetylethyl)-2-benzylbenzooxazolium bromide, 3-(2-acetylethyl)-2-benzylbenzoselenazolium bromide, 2-methyl-3-[3-(phenylhydrazino)propyl]benzothiazolium bromide, 1,2-dihydro-3-methyl-phenylpyrido [2,1-b]-benzothiazolium bromide, 1,2-dihydro-3-methyl-4-phenylpyrido[2,1-b]benzoselenazolium bromide and 4,4'-ethylenebis(1,2-dihydro-3-methylpyrido[2,1-b]benzothiazolium) bromide; and 5-(3-ethyl-2-benzothiazolinylidene)-3-[4-(2-formylhydrazino)phenyl]phenyl] rhodanine, 1,3-bis[4-(2-formylhydrazino)phenyl]thiourea, 7-(3-ethoxythiocarbonylaminobenzamido)-9-methyl-10-propargyl-1,2,3,4-tetrahydroacrydiniumtrifluoromethane sulfonate, and 1-formyl-2-[4-{3-(2-methoxyphenyl)ureido}phenyl]hydrazine.

The photographic light-sensitive material having the silver halide emulsion layer used in the invention, after being imagewise exposed, is either overall exposed or developed in the presence of a fogging agent, thereby forming a direct positive image.

The developing agent usable in the developer solution for use in developing the photographic light-sensitive material of the invention include ordinary silver halide developing agents such as hydroquinone, hydroxybenzenes, aminophenols, 3-pyrazolones, ascorbic acid and its derivatives, reductones, phenylenediamines, and mixtures thereof; to be concrete, hydroquinone, aminophenol, N-methylaminophenol, 1-phenyl-3-pyrazolidone, 1-phenyl-4,4-dimethyl-3-pyrazolidone, 1-phenyl-4-methyl-4-hydroxymethyl-3-pyrazolidone, ascorbic acid, N,N-diethylamino-o-toluidine, 4-amino-3-methyl-N-ethyl-N-(β-methanesulfonamidoethyl)aniline, 4-amino-3-methyl-N-ethyl-N-(β-hydroxyethyl)aniline and 4-amino-N-ethyl-N-(β-hydroxyethyl)aniline. It is possible to incorporate any of these fogging agents into the silver halide emulsion so as to have the fogging agent react with the silver halide while being immersed in a high pH aqueous solution.

The developer solution used in the invention may contain a further specific fogging agent and a development

restrainer. Alternatively, it is possible to arbitrarily incorporate such photographic additives for a developer solution into the component layer(s) of the photographic light-sensitive material.

For the silver halide photographic light-sensitive material in the invention there may be used known photographic additives.

The above-mentioned known photographic additives include the following compounds described in Research Disclosure RD 17643 and RD 18716.

| Additives | RD 17643 | | RD 18716 | |
|---|---|---|---|---|
| | Page | Section | Page | Section |
| Chemical sensitizers | 23 | III | 648 | upper right |
| Sensitizing dyes | 23 | IV | 648 | " |
| Development accelerators | 29 | XXI | 648 | " |
| Antifoggants | 24 | VI | 649 | lower right |
| Stabilizers | " | | | " |
| Antistain agents | 25 | VII | 650 | left to right |
| Image stabilizers | 25 | VII | | |
| UV absorbents | 25-26 | VII | 649 | right to 650 left |
| Filter dyes | " | | | " |
| Brightening agents | 24 | V | | |
| Hardeners | 26 | X | 651 | right |
| Coating aids | 26-27 | XI | 650 | right |
| Surfactants | 26-27 | XI | 650 | right |
| Plasticizers | 27 | XII | 650 | right |
| Sliding agents | " | | | " |
| Antistatic agents | " | | | " |
| Matting agents | 28 | XVI | 650 | right |
| Binders | 29 | IX | 651 | right |

The silver halide emulsion of the light-sensitive material of the invention may contain a dye forming coupler capable of effecting a coupling reaction with the oxidation product of a color developing agent to thereby form a dye. The dye forming coupler is usually selected for each individual emulsion layer so as to form a dye that absorbs the spectral light to which the corresponding emulsion is sensitive, and thus, a yellow dye forming coupler is used for a blue-sensitive emulsion layer, a magenta dye forming coupler for a green-sensitive emulsion layer, and a cyan dye forming coupler for a red-sensitive emulsion layer. However, the silver halide color photographic light-sensitive material may, depending on purposes, be prepared with other coupler-emulsion layer combinations different from the above-mentioned combination.

## EXAMPLES

The invention is illustrated further in detail by the following examples, but the invention is not limited thereto.

### EXAMPLE 1

A paper support of 110μm in thickness having one side thereof laminated with polyethylene and having the other side thereof laminated with polyethylene containing titanium oxide in an amount of 15% by weight thereof was used to coat the following component layers on the titanium oxide-containing side of the support, whereby a multilayer color photographic light-sensitive material was prepared.

Preparation of emulsion EM-1

To an aqueous osein gelatin solution at a temperature controlled to 40°C were added both an aqueous ammoniacal silver nitrate solution and an aqueous potassium bromide and sodium chloride solution (at a molar KBr:NaCl ratio of 95:5) simultaneously in accordance with a controlled double-jet precipitation process, whereby a cubic silver

chlorobromide core emulsion having an average grain diameter of 30µm was obtained. During the above process, pH and pAg were controlled so as to obtain cubic crystal grains. To the obtained core emulsion were added an aqueous ammoniacal silver nitrate solution and an aqueous potassium bromide and sodium chloride solution (at a molar KBr: NaCl ratio of 40:60) simultaneously by the controlled double-jet precipitation process to cover the core grain of the above emulsion and to form a shell phase until the average grain diameter became 0.42µm. In this instance, pH and pAg were controlled so that cubic grains can be obtained.

To the above emulsion, after being washed to remove the water-soluble salts therefrom, gelatin was added to obtain an emulsion EM-1. The distribution broadness of the grain diameters of the emulsion EM was 8%.

Preparation of emulsion EM-2

To an aqueous osein gelatin solution at a temperature controlled to 40°C, were added both an aqueous ammoniacal silver nitrate solution and an aqueous potassium bromide and sodium chloride solution (at a molar KBr:NaCl ratio of 95:5) simultaneously according to the controlled double-jet precipitation process, whereby a cubic silver chlorobromide emulsion having an average grain diameter of 18µm was obtained. In this instance, pH and pAg were controlled so that cubic silver halide grains can be obtained. To the above-produced core emulsion were added an aqueous ammonical silver nitrate solution and an aqueous potassium bromide and sodium chloride solution (at a molar KBr:NaCl ratio of 40:60) simultaneously according to the controlled double-jet precipitation process to cover the above core grain and to form a shell phase until the average grain diameter became 0.25µm, during which process pH and pAg were controlled so that cubic silver halide grains can be obtained.

To the above prepared emulsion, after being washed to remove the water-soluble salts therefrom, gelatin was added to obtain an emulsion EM-2. The distribution broadness of the grain diameters of the emulsion EM2 was 8%.

Preparation of blue-sensitive emulsion EM-B

The emulsion EM-1 was spectrally sensitized by adding a sensitizing dye D-1 thereto, and a compound T-1 was added in an amount of 600mg per mol of silver, whereby a blue-sensitive emulsion EM-B was prepared.

Preparation of green-sensitive emulsion EM-G

A green-sensitive emulsion EM-G was prepared in the same manner as in the blue-sensitive emulsion except that the emulsion EM-2 was spectrally sensitized by adding sensitizing dye D-2 thereto.

Preparation of red-sensitive emulsion EM-R

A red-sensitive emulsion EM-R was prepared in the same manner as in the blue-sensitive emulsion except that the emulsion EM-2 was spectrally sensitized by adding sensitizing dyes D-3 and D-4 thereto.

Preparation of panchromatic emulsion EM-P

A panchromatic emulsion EM-P was prepared in the same manner as in the blue-sensitive emulsion except that the emulsion EM-1 was spectrally sensitized by adding sensitizing dyes D-1, D-2, D-3 and D-4 thereto.

In the emulsions of EM-P, EM-B, EM-G and EM-R, the added amounts of the sensitizing dyes were adjusted to give a ratio of the sensitivity of EM-P to that of EM-B, EM-G and EM-R of 0.8 to 1.5.

Compound T-1: 4-hydroxy-6-methyl-1,3,3a,7-tetrazaindene.

D − 1

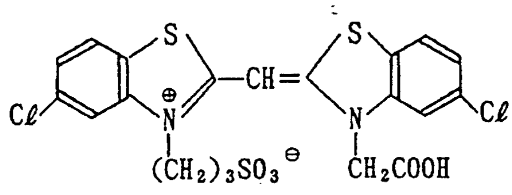

D - 2

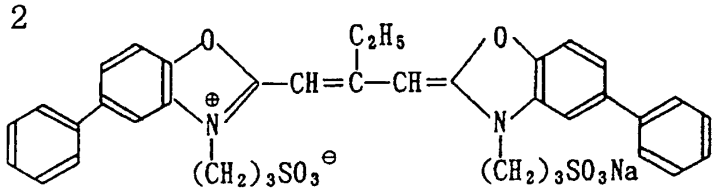

D - 3

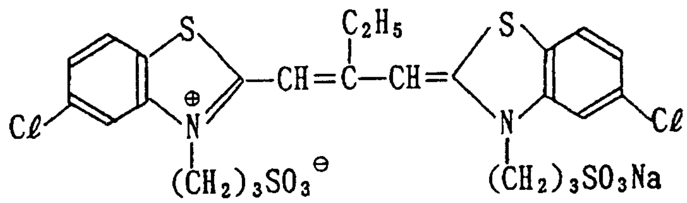

D - 4

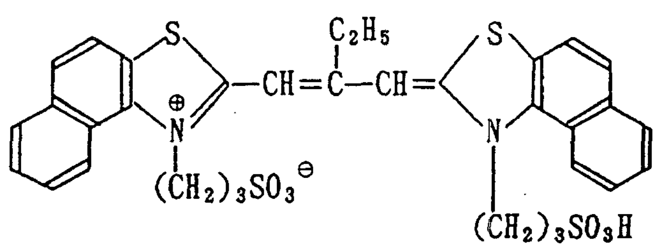

D - 5

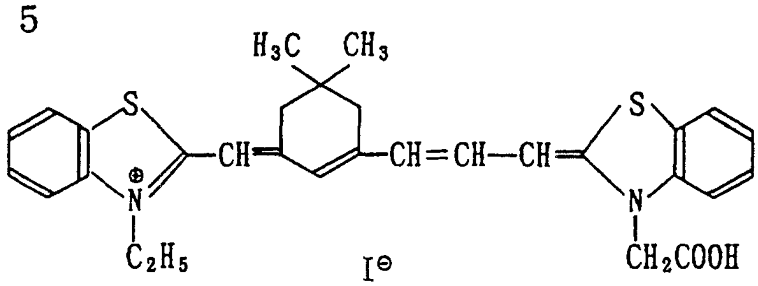

The above emulsions EM-B, EM-G and EM-R were used to prepare a color photographic light-sensitive material sample 1-1 comprised of the following component layers, wherein the foregoing support had its obverse side coated with the following layers 1 to 8 and had the other side coated with a layer 10, and in addition, coating aids SA-1 to SA-2 and hardeners H-1 and H-2 were used, whereby a sample 1-1 was prepared.

| | |
|---|---|
| SA-1: | Sodium sulfo-di(2-ethylhexyl) succinate |
| SA-2: | Sodium sulfo-di(2,2,3,3,4,4,5,5-octafluoropentyl) succinate |
| H-1: | Sodium 2,4-dichloro-6-hydroxy-s-triazine |
| H-2: | Tetrakis(vinylsulfonylmethyl)methane |

| Layer | Component | Coatinq wt(g/m$^2$) |
|---|---|---|
| Layer 8 (UV absorbing layer) | Gelatin | 0.78 |
| | UV absorbent UV-1 | 0.065 |
| | UV absorbent UV-2 | 0.120 |
| | UV absorbent UV-3 | 0.160 |
| | Solvent SO-2 | 0.1 |
| | Silica matting agent | 0.03 |
| Layer 7 (Blue-sensitive layer) | Gelatin | 1.43 |
| | Blue-sensitive emulsion EM-B (coating weight of silver) | 0.4 |
| | Panchromatic emulsion EM-P (coating weight of silver) | 0.1 |
| | Yellow coupler YC-1 | 0.82 |
| | Antistain agent AS-2 | 0.025 |
| | Solvent SO-1 | 0.82 |
| | Restrainers ST-1, ST-2, T-1 (1:1:1, molar ratio) | 0.0036 |
| Layer 6 (Intermediate layer) | Gelatin | 0.54 |
| | Anti-color-mixing agent (a mixture of AS-1, 3, 4, 5, 6 in equal amount | 0.055 |
| | Solvent SO-2 | 0.072 |
| Layer 5 (Yellow colloidal layer) | Gelatin | 0.42 |
| | Yellow colloidal silver | 0.1 |
| | Anti-color-mixing agent (a mixture of AS-1, 3, 4, 5, 6 in equal amount | 0.04 |
| | Solvent SO-2 | 0.049 |
| | Polyvinyl pyrrolidone PVP | 0.047 |
| | Antiirradiation dye AI-3 | 0.03 |
| Layer 4 (Intermediate layer) | Gelatin | 0.54 |
| | Anti-color mixing agent (a mixture of AS-1, 3, 4, 5, 6 in equal amount | 0.055 |
| | Solvent SO-2 | 0.072 |
| Layer 3 (Green-sensitive layer) | Gelatin | 1.43 |
| | Green-sensitive emulsion EM-G (Coating weight of silver) | 0.40 |
| | Panchromatic emulsion EM-P | |
| | (Coating weight of silver) | 0.1 |
| | Magenta coupler MC-1 | 0.25 |
| | Yellow coupler YC-2 | 0.06 |
| | Antistain agent AS-2 | 0.019 |
| | Solvent SO-1 | 0.31 |
| | Restrainers ST-1, ST-2, T-1 (1:1:1, molar ratio) | 0.0036 |

(continued)

| Layer | Component | Coatinq wt(g/m2) |
|---|---|---|
| Layer 2 (Intermediate layer) | Gelatin | 0.75 |
| | Anti-color-mixing agent (a mixture of AS-1, 3, 4, 5, 6 in equal amount) Solvent SO-2 | 0.072 |
| | Antiirradiation dye AI-1 | 0.01 |
| | Antiirradiation dye AI-2 | 0.01 |
| Layer 1 (Red-sensitive layer) | Gelatin | 1.38 |
| | Red-sensitive emulsion EM-R (Coating weight of silver) | 0.30 |
| | Panchromatic emulsion EM-P (Coating weight of silver) | 0.06 |
| | Cyan coupler CC-2 | 0.44 |
| | Solvent SO-1 | 0.31 |
| | Antistain agent AS-2 | 0.015 |
| | Restrainers ST-1, ST-2, T-1 (1:1:1, molar ratio) | 0.0036 |
| Layer 10 (Backing layer) | Gelatin | 6.00 |
| | Silica matting agent | 0.65 |

The silver coating weight in above is in silver equivalent.
SO-1: Trioctyl phosphate
SO-2: Dioctyl phthalate
AS-1: 2,4-di-t-octylhydroquinone
AS-2: 2,4-di-butylhydroquinone
ST-1: 1-(3-acetamidophenyl)-5-mercaptotetrazole
AT-2: N-benzyladenine

UV − 1

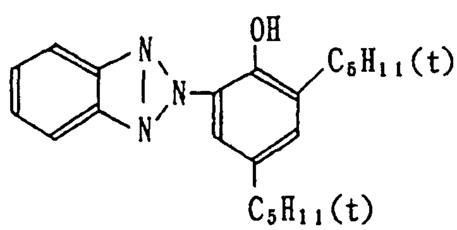

UV − 2

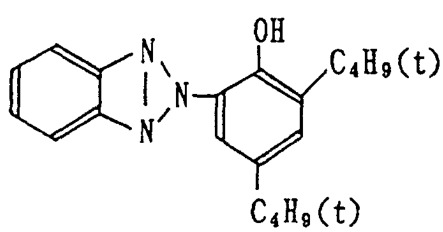

UV-3

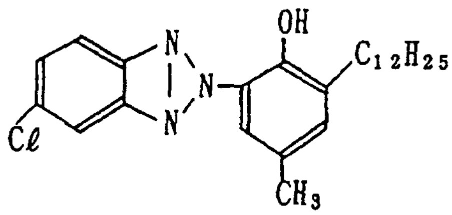

YC-1

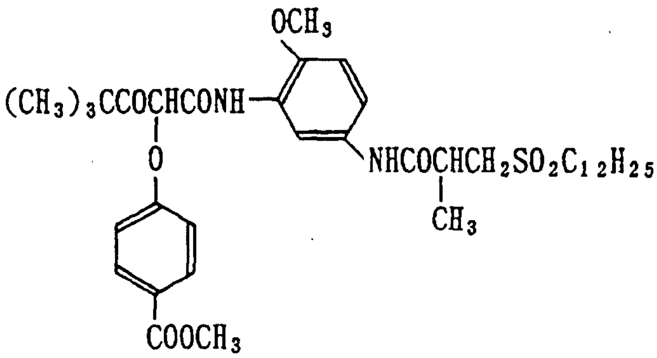

YC-2

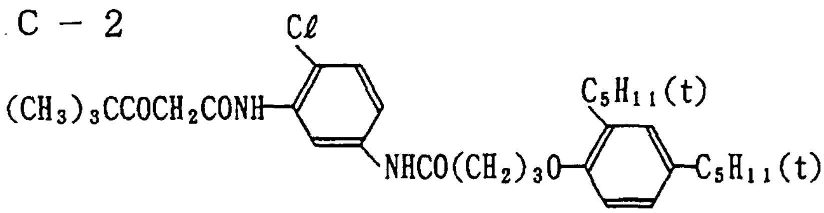

MC-1

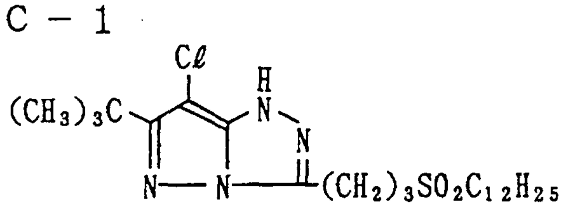

CC-2

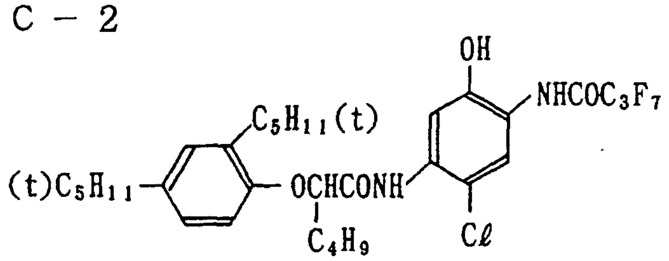

AI-1

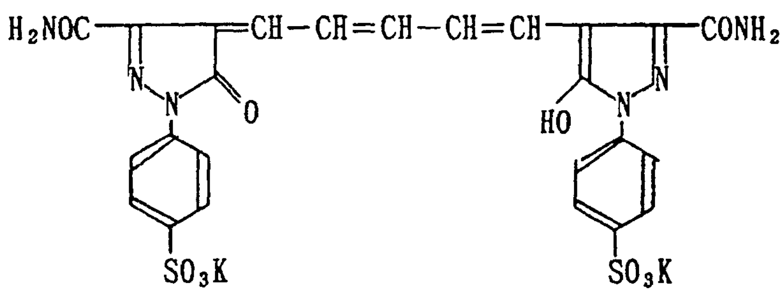

AI-2

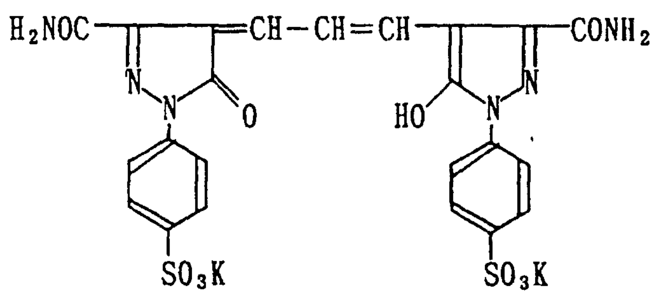

A I − 3

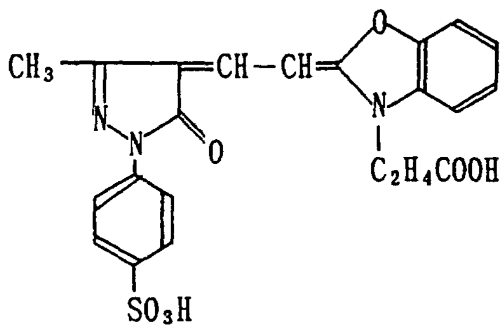

A S − 3

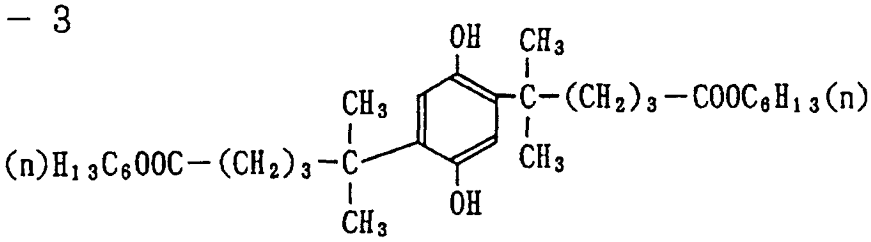

A S − 4

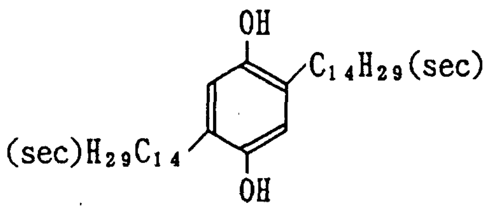

A S − 5

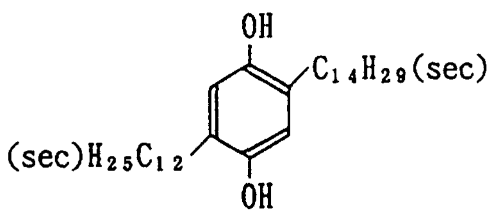

AS-6

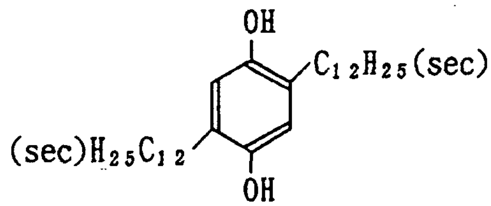

Oil-soluble-dye 1:

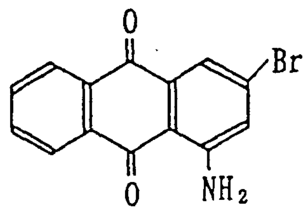

Oil-soluble-dye 2:

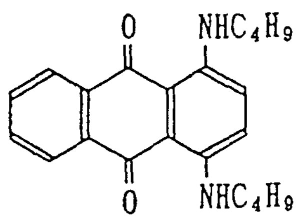

Sample 1-2 was prepared in the same manner as in the obtained Sample 1-1 except that the panchromatic emulsion EM-P was eliminated from Layer 7, the silver coating weight of the blue-sensitive emulsion EM-B was changed to 0.5g/$m^2$, the panchromatic emulsion EM-P was eliminated from Layer 3, the silver coating weight of the green-sensitive emulsion EM-G was changed to 0.5g/$m^2$, the panchromatic emulsion EM-P was eliminated from Layer 1 and the silver coating weight of the red-sensitive emulsion EM-R was changed to 0.36g/$m^2$. Samples 1-3 to 1-6 were prepared in the same manner as in Sample 1-2 except that the cyan coupler in Layer 1 of Sample 1-2 was changed to the cyan couplers (in equimolar amounts to CC-2) as listed in Table 1.

Samples 1-7 to 1-10 were prepared in the same manner as in Sample 1-1 except that the cyan coupler of the Layer 1 of Sample 1-1 was changed to the cyan couplers (in equimolar amounts to CC-2) as listed in Table 1.

Samples 1-11 to 1-14 were prepared in the same manner as in Samples 1-7 to 1-10, respectively, except that a white pigment layer of the following composition was provided between the Layer 1 and the support of each sample.

| White pigment layer | |
|---|---|
| Gelatin | 1.0g |
| Rutile-type titanium dioxide | 3.0g |

Each of the above-obtained Samples 1-1 to 1-14 was exposed to light under the following exposure condition-1 through halftone originals for black image and for cyan image in close contact therewith, then to light under the following exposure condition-2 through halftone originals for black image and for magenta image in close contact

therewith, and then to light under the following exposure condition-3 through halftone originals for black image and for yellow image in close contact therewith.

Exposure condition-1

Each light-sensitive material sample was exposed through a red filter (Wratten No.26) and an ND filter to a white light for 0.5 second at a minimum exposure amount obtained by adjusting the density of the ND filter so as to minimize the processed red light density.

Exposure condition-2

Each light-sensitive material sample was exposed through a green filter (Wratten No.58) and an ND filter to a white light for 0.5 second at a minimum exposure amount obtained by adjusting the density of the ND filter so as to minimize the processed green light density.

Exposure condition-3

Each light-sensitive material sample was exposed through a blue filter (Wratten No.47B) and an ND filter to a white light for 0.5 second at a minimum exposure amount obtained by adjusting the density of the ND filter so as to minimize the processed blue light density.

The light source utilized for the above exposure conditions-1 to -3 was a daylight-type fluorescent lamp.

The above exposed samples were each processed under the following processing condition-1 for image formation.

The processing conditions and the compositions of the processing solutions used are as follows:

| Processing procedure-1 | Temperature | Time |
|---|---|---|
| Immersing in developer | 37°C | 12 seconds |
| Light fogging | -- | 12 seconds (1 lux) |
| Developing | 37°C | 95 seconds |
| Bleach-fixing | 35°C | 45 seconds |
| Stabilizing | 25-30°C | 90 seconds |
| Drying | 60-85°C | 40 seconds |

Compositions of the processing solutions

| Color developer | |
|---|---|
| Benzyl alcohol | 15.0ml |
| Ceric sulfate | 0.015g |
| Ethylene glycol | 8.0ml |
| Potassium sulfite | 2.5g |
| Potassium bromide | 0.6g |
| Sodium chloride | 0.2g |
| Potassium carbonate | 25.0g |
| T-1 | 0.1g |
| Hydroxylamine sulfate | 5.0g |
| Sodium diethylenetriaminepentaacetate | 2.0g |
| 4-amino-N-ethyl-N-(β-hydroxyethyl)aniline sulfate | 4.5g |
| Brightening agent (4,4'-diaminostilbenedisulfonic acid derivative) | 1.0g |
| Potassium hydroxide | 2.0g |
| Diethylene glycol | 15.0ml |
| Water to make 1 liter, adjust pH to 10.15. | |

| Bleach-fix | |
|---|---|
| Ferric ammonium diethylenetriaminepentaacetate | 90.0g |
| Diethylenetrimainepentaacetic acid | 3.0g |
| Ammonium thiosulfate (70% aqueous solution) | 180 ml |
| Ammonium sulfite (40% aqueous solution) | 27.5ml |
| 3-mercapto-1,2,4-triazole | 0.15g |
| Adjust pH to 7.1 with potassium carbonate | |
| or glacial acetic acid, | |
| Water to make 1 liter. | |

| Stabilizer | |
|---|---|
| o-Phenylphenol | 0.3g |
| Potassium sulfite (50% aqueous solution) | 12 ml |
| Ethylene glycol | 10 g |
| 1-hydroxyethylidene-1,1-diphosphonic acid | 2.5g |
| Bismuth chloride | 0.2g |
| Zinc sulfate, heptahydrate | 0.7g |
| Ammonium hydroxide (28% aqueous solution) | 2.0g |
| Polyvinylpyrrolidone K-17 | 0.2g |
| Brightening agent (4,4'-diaminostilbenedisulfonic acid derivative) | 2.0g |
| Water to make 1 liter, | |

Adjust pH to 7.5 with ammonium hydroxide or sulfuric acid.

The stabilization treatment was made in the double bath countercurrent system.

The following are the prescriptions of replenishers necessary for conducting a continuous run of processings.

| Color developer replenisher | |
|---|---|
| Benzyl alcohol | 18.5ml |
| Ceric sulfate | 0.015g |
| Ethylene glycol | 10.0ml |
| Potassium sulfite | 2.5g |
| Potassium bromide | 0.3g |
| Sodium chloride | 0.2g |
| Potassium carbonate | 25.0g |
| T-1 | 0.1g |
| Hydroxylamine sulfate | 5.0g |
| Sodium diethylenetriaminepentaacetate | 2.0g |
| 4-Amino-N-ethyl-N-(β-hydroxyethyl)aniline sulfate | 5.4g |
| Brightening agent (4,4'-diaminostilbenedisulfonic acid derivative) | 1.0g |
| Potassium hydroxide | 2.0g |
| Diethylene glycol | 18.0ml |
| Water to make 1 liter, | |
| Adjust pH to 10.35. | |

Bleach-fix replenisher

The same as the foregoing bleach-fix.

Stabilizer replenisher

The same as the foregoing stabilizer.
The replenishing amount of each of the developer replenisher, bleach-fix replenisher and stabilizer replenisher was 320ml per $m^2$ of the light-sensitive material.
Another part of each sample was exposed under the same condtions as in the above fresh processing solutions and processed in the same manner as in processing procedure-1 except that the processing was carried out with developer, bleach-fix and stabilizer which were obtained after sample 1-4 was running-processed in processing procedure 1 until the developer replenisher volume became three times the capacity of the developer bath tank.
The resulting image was evaluated as follows: The likeness of the cyan solid image area to a printing ink standard was visually checked to give a three-stage functional evaluation which comprises A: it has a close resemblance to the printing ink, B: it has a slight resemblance to the printing ink, C: it has no resemblance to the printing ink.
Regarding changes in the color tone of the neutral area of the halftone image, there were measured a green-light density DG and a red-light density DR at a neutral image portion of each sample which corresponds to original Y, M and C charts each having a dot percentage of 20%, 50% or 80% which are different in brightness and the DR/DG ratio was calculated. The calculated DR/DG was represented relative to DR/DG of the image at a 50% dot percentage obtained by processing with fresh processing solutions as 100. Thus, the change in the neutrality due to dot percentages or processing conditions was examined. The closer to 100 the value is, the more preferable the sample.
The reproducibility of the shadow portions of the image was visually checked. The evaluation was carried out with the followint three criteria: A: excellent reproducibility, B: good reproducibility and C: poor reproducibility.
The results are collectively shown in Table 1.

Table 1

| Sample No. | Cyan coupler | Layer 1 EM-P | Neutrality | | | | Image tightness |
|---|---|---|---|---|---|---|---|
| | | | Fresh sol | | | Running sol 50% | |
| | | | 80% | 50% | 20% | | |
| 1-1 (Comp.) | CC-2 | Present | 87 | 100 | 112 | 113 | A |
| 1-2 ( " ) | CC-2 | None | 89 | 100 | 110 | 111 | B |
| 1-3 ( " ) | C-7 | None | 81 | 100 | 119 | 120 | C |
| 1-4 ( " ) | C-20 | None | 80 | 100 | 118 | 122 | C |
| 1-5 ( " ) | C-26 | None | 81 | 100 | 120 | 118 | C |
| 1-6 ( " ) | C-34 | None | 82 | 100 | 118 | 116 | C |
| 1-7 (Inv.) | C-7 | Present | 95 | 100 | 103 | 102 | A |
| 1-8 ( " ) | C-20 | Present | 94 | 100 | 103 | 103 | A |
| 1-9 ( " ) | C-26 | Present | 94 | 100 | 104 | 104 | A |
| 1-10 ( " ) | C-34 | Present | 95 | 100 | 104 | 103 | A |
| 1-11 ( " ) | C-7 | Present | 97 | 100 | 103 | 102 | A |
| 1-12 ( " ) | C-20 | Present | 97 | 100 | 103 | 103 | A |
| 1-13 ( " ) | C-26 | Present | 97 | 100 | 103 | 104 | A |
| 1-14 ( " ) | C-34 | Present | 97 | 100 | 103 | 103 | A |

As is apparent from Table 1, each sample in accordance with the invention is satisfactory in respect of the neutrality of the halftone image obtained therefrom even when the dot percentage ratio changes, and is stable even when processed under conditions fluctuating. It is also apparent that the above fact is further improved in the samples each having a white pigment layer provided between the support and Layer 1 thereof.

## EXAMPLE 2

A paper support of 110µm in thickness having one side thereof laminated with polyethylene and having the other side thereof laminated with polyethylene containing titanium oxide in an amount of 15% by weight thereof was used to coat the following component layers on the titanium oxide-containing side of the support, whereby a multilayer color photographic light-sensitive material was prepared.
The foregoing emulsions EM-B, EM-G, EM-R and EM-P were used to prepare a color photographic light-sensitive material sample 2-1 composed of the following layers: On the titanium oxide-containing side of the paper

support was coated in order Layers 1 to 10, and on the reverse side thereof was coated Layer 11. In the coating of all these layers, there were used coating aids SA-1 and SA-2, and hardeners H-1 and H-2.

| Layer | Constituent | Coating wt(g/$m^2$) |
|---|---|---|
| Layer 10 (UV absorbing layer) | Gelatin | 0.78 |
| | UV absorbent UV-1 | 0.065 |
| | UV absorbent UV-2 | 0.120 |
| | UV absorbent UV-3 | 0.160 |
| | Solvent SO-2 | 0.1 |
| | Silica matting agent | 0.03 |
| Layer 9 (Auxiliary image layer) | Gelatin | 1.20 |
| | Panchromatic emulsion EM-P | 0.26 |
| | Yellow coupler YC-1 | 0.20 |
| | Magenta coupler MC-1 | 0.06 |
| | Cyan coupler CC-2 | 0.10 |
| | Solvent SO-1 | 0.40 |
| Layer 8 (Intermediate layer) | Gelatin | 0.75 |
| | Anti-color-mixing agent (a mixture of AS-1, -3, -4, -5, -6 in equal amount) | 0.055 |
| | Solvent SO-2 | 0.072 |
| Layer 7 (Blue-sensitive layer) | Gelatin | 1.43 |
| | Blue-sensitive emulsion EM-B in silver equivalent | 0.4 |
| | Yellow coupler YC-1 Restrainer ST-1, ST-2, T-1 | 0.82 |
| Layer 6 (Intermediate layer) | Gelatin | 0.54 |
| | Anti-color-mixing agent (a mixture of AS-1, -3, -4, -5, -6 in equal amount) | 0.055 |
| | Solvent SO-2 | 0.072 |
| Layer 5 (Yellow colloidal layer) | Gelatin | 0.42 |
| | Yellow colloidal silver | 0.1 |
| | Anti-color-mixing agent (a mixture of AS-1, -3, -4, -5, -6 in equal amount) | 0.04 |
| | Solvent SO-2 | 0.049 |
| | Polyvinylpyrrolidone (PVP) | 0.047 |
| | Antiirradiation dye AI-3 | 0.03 |
| Layer 4 (Intermediate layer) | Gelatin | 0.54 |
| | Anti-color-mixing agent (a mixture of AS-1, -3, -4, -5, -6 in equal amount) | 0.055 |
| | Solvent SO-2 | 0.072 |

(continued)

| Layer | Constituent | Coating wt(g/m$^2$) |
|---|---|---|
| Layer 3 (Green-sensitive layer) | Gelatin | 1.43 |
| | Green-sensitive emulsion EM-G in silver equivalent | 0.40 |
| | Magenta coupler MC-1 | 0.25 |
| | Yellow coupler YC-2 | 0.06 |
| | Antistain agent AS-2 | 0.019 |
| | Solvent SO-1 | 0.31 |
| | Restrainer ST-1, ST-2, T-1 | |
| Layer 2 (Intermediate layer) | Gelatin | 0.75 |
| | Anti-color-mixing agent (a mixture of AS-1, -3, -4, -5, -6 in equal amount) | 0.055 |
| | Solvent SO-2 | 0.072 |
| | Antiirradiation agent AI-1 | 0.01 |
| | Antiirradiation agent AI-2 | 0.01 |
| Layer 1 (Red-sensitive layer) | Gelatin | 1.38 |
| | Red-sensitive emulsion EM-R in silver equivalent | 0.38 |
| | Cyan coupler CC-2 | 0.44 |
| | Solvent SO-1 | 0.31 |
| | Antistain agent AS-2 | 0.015 |
| | Restrainer ST-1, ST-2, T-1 | 6.00 |
| Layer 11 (Backing layer) | Gelatin | 6.00 |
| | Silica matting agent | 0.65 |

Sample 2-2 was prepared in the same manner as in the above obtained Sample 2-1 except that the auxiliary image layer of the Layer 9 and the intermediate layer of the Layer 8 of Sample 2-1 were eliminated, the silver coating weight of the blue-sensitive emulsion EM-B of the Layer 7 was changed to 0.5g/m$^2$, the coating silver weight of the green-sensitive emulsion EM-G of the Layer 3 was changed to 0.5g/m$^2$, and the silver coating weight of the red-sensitive emulsion EM-R of the Layer 1 was changed to 0.36g/m$^2$.

Samples 2-3 and 2-4 were prepared in the same manner as in Sample 2-2 except that the cyan coupler of the Layer 1 of Sample 2-2 was replaced by the cyan couplers (in equimolar amounts to CC-2) listed in Table 2.

Samples 2-5 and 2-6 were prepared in the same manner as in Sample 2-1 except that the cyan coupler of the Layer 1 of Sample 2-1 was changed to the relevant cyan couplers (in equimolar amounts to CC-2) listed in Table 2.

Samples 2-7 and 2-8 were prepared in the same manner as in Samples 2-5 and 2-6 except that a white pigment layer of the following composition was provided between the Layer 1 and the support.

| White pigment layer | Coating wt(g/m$^2$) |
|---|---|
| Gelatin | 1.0 |
| Rutile-type titanium dioxide | 1.5 |

Each of the obtained Samples 2-1 to 2-8 was exposed in the same manner as in Example 1 and processed in the same manner as in Example 1. The obtained image was examined with respect to changes in the tone of the solid cyan image and that of the neutral image

The obtained results are shown in Table 2.

Table 2

| Sample No. | Cyan coupler | Auxiliary image layer EM-P | Neutrality | | | |
|---|---|---|---|---|---|---|
| | | | Fresh sol | | | Running sol 50% |
| | | | 80% | 50% | 20% | |
| 2-1 (Comp.) | CC-2 | Present | 86 | 100 | 113 | 114 |
| 2-2 ( " ) | CC-2 | None | 88 | 100 | 111 | 112 |
| 2-3 ( " ) | C-9 | None | 83 | 100 | 118 | 120 |
| 2-4 ( " ) | C-29 | None | 81 | 100 | 118 | 121 |
| 2-5 (Inv.) | C-9 | Present | 95 | 100 | 103 | 103 |
| 2-6 ( " ) | C-29 | Present | 94 | 100 | 103 | 104 |
| 2-7 ( " ) | C-9 | Present | 97 | 100 | 102 | 102 |
| 2-8 ( " ) | C-29 | Present | 97 | 100 | 102 | 103 |

As is apparent from Table 2, each sample in accordance with the invention is satisfactory in respect of the neutrality of the halftone image obtained therefrom even when the dot percentage ratio changes, and is stable even when processed under conditions fluctuating. It is also apparent that the above fact is further improved in the samples each having a white pigment layer provided between the support and Layer 1 thereof.

## Claims

**1.** A silver halide color photographic material comprising a support and provided thereon, a yellow image forming silver halide emulsion layer comprising a first silver halide emulsion, a magenta image forming silver halide emulsion layer comprising a second silver halide emulsion and a cyan image forming silver halide emulsion layer comprising a third silver halide emulsion,

said first, second and third emulsions having spectral sensitivity wavelength regions different from one another;

characterised in that:

at least one of said yellow, magenta and cyan image forming silver halide emulsion layers further contains a fourth silver halide emulsion having at least a portion of a spectral sensitivity wavelength region of said yellow image forming silver halide emulsion layer, at least a portion of a spectral sensitivity wavelength region of a magenta image forming silver halide emulsion layer and at least a portion of a spectral sensitivity wavelength region of the cyan image forming silver halide emulsion layer to give a ratio of the sensitivity of said fourth silver halide emulsion to that of said first, second and third silver halide emulsion of 1/10 to 10,

wherein the cyan image forming silver halide emulsion layer contains at least one selected from compounds represented by the following Formulas I, II, III, and IV:

Formula I

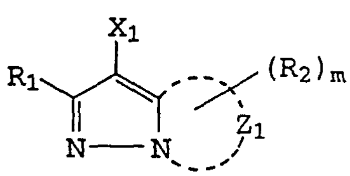

Formula II

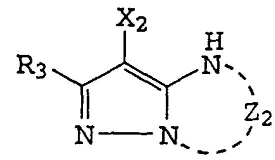

Formula III

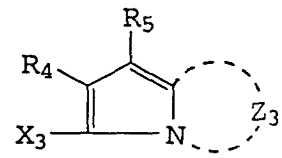

Formula IV

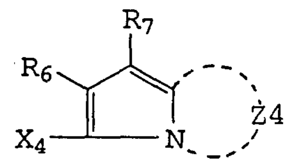

wherein $R_1$ represents a hydrogen or a substituent; $R_2$ represents a substituent; m represents the number of $R_2$, provided that when m is 0, the substituent of $R_1$ represents an electron attractive group having a Hammett's substituent constant σp of not less than 0.20, and when m is 1 or 2, one of $R_1$ and $R_2$ represents an electron attractive group having a Hammett's substituent constant σp of not less than 0.20; and $Z_1$ represents a group of non-metallic atoms necessary to form a nitrogen -containing 5-membered heterocyclic ring; $R_3$ represents a hydrogen atom or a substituent; $Z_2$ represents a group of non-metallic atoms necessary to condense with a pyrazole ring together with -NH- to form a nitrogen-containing 6-membered heterocyclic ring; $R_4$ and $R_5$ independently represent an electron attractive group having a Hammett's substituent constant σp of not less than 0.20, provided the total σp value of $R_4$ and $R_5$ is not less than 0.65; $Z_3$ is a group of non-metallic atoms necessary to form a nitrogen-containing 5-membered heterocyclic ring; $R_6$ and $R_7$ independently represent a hydrogen atom or a substituent; $Z_4$ is a group of non-metallic atoms necessary to form a nitrogen-containing 6-membered ring; and $X_1$, $X_2$, $X_3$ and $X_4$ independently represent a hydrogen atom or a group capable of splitting upon coupling reaction with an oxidized product of a color developing agent.

**2.** The material of claim 1, wherein the substituent of $R_1$ or $R_2$ having a Hammett's substituent constant σp of not less than 0.20 represents a sulfonyl, sulfinyl, sulfonyloxy, sulfamoyl, phosphoryl, carbamoyl, acyl, acyloxy, oxycarbonyl, carboxyl, cyano, nitro, halogenated alkyl, halogenated alkoxy, halogenated aryloxy, pyrrolyl or tetrazolyl group or a halogen atom; the substituents of $R_1$ and $R_2$ other than the substituents having a Hammett's substituent constant σp of not less than 0.20 represent an alkyl, aryl, anilino, acylamino, sulfonamido, alkylthio, arylthio, alkenyl, cycloalkyl, cycloalkenyl, alkynyl, heterocyclic, alkoxy, aryloxy, heterocyclic oxy, siloxy, amino, alkylamino, imido, ureido, sulfamoylamino, alkoxycarbonylamino, aryloxycarbonylamino, alkoxycarbonyl, aryloxycarbonyl, heterocyclic thio, thioureido, hydroxy or mercapto group, spiro compound residues or closslinked hydrocarbon compound residues; the nitrogen-containing 5-membered heterocyclic ring formed with $Z_1$ represents a pyrazole, imidazole, benzimidazole, triazole or tetrazole ring; the substituent of $R_3$ represents an alkyl, aryl, aniline, acylamino, sulfonamido, alkylthio, arylthio, alkenyl or cycloalkyl group, a halogen atom, a cycloalkenyl, alkynyl, heterocyclic, sulfonyl, sulfinyl, phosphonyl, acyl, carbamoyl, sulfamoyl, cyano, alkoxy, sulfonyloxy, aryloxy, heterocyclicoxy, siloxy, acyloxy, carbamoyloxy, amino, alkylamino, imido, ureido, sulfamoylamino, alkoxycarbonylamino, aryloxycarbonylamino, alkoxycarbonyl, aryloxycarbonyl, heterocyclicthio, thioureido, carboxyl, hydroxyl, mercapto, nitro or sulfo group, a spiro compound residue or a closslinked hydrocarbon compound residue; the nitrogen-containing 6-membered heterocyclic ring formed with $Z_2$ represents a group containing two nitrogen atoms and a carbonyl group; $R_4$ and $R_5$ independently represent a sulfonyl, sulfinyl, sulfonyloxy, sulfamoyl, phosphoryl, carbamoyl, acyl, acyloxy, oxycarbonyl, carboxyl, cyano, nitro, halogenated alkyl, halogenated alkoxy, halogenated aryloxy, pyrrolyl or tetrazolyl group or a halogen atom; the nitrogen-containing 5-membered heterocyclic ring formed with $Z_3$ represents a pyra-

zole, imidazole or tetrazole ring; the substituent of $R_6$ or $R_7$ represents an alkyl, aryl, aniline, acylamino, sulfonamido, alkylthio, arylthio, alkenyl or cycloalkyl group, a halogen atom, a cycloalkenyl, alkynyl, heterocyclic, sulfonyl, sulfinyl, phosphonyl, acyl, carbamoyl, sulfamoyl, cyano, alkoxy, sulfonyloxy, aryloxy, heterocyclicoxy, siloxy, acyloxy, carbamoyloxy, amino, alkylamino, imido, ureido, sulfamoylamino, alkoxycarbonylamino, aryloxycarbonylamino, alkoxycarbonyl, aryloxycarbonyl, heterocyclicthio, thioureido, carboxyl, hydroxyl, mercapto, nitro or sulfo group, a spiro compound residue or a closslinked hydrocarbon compound residue; the nitrogen-containing 6-membered heterocyclic ring formed with $Z_4$ has a dissociation group having $pK_a$ of 3 to 12; and the group represented by $X_1$, $X_2$, $X_3$ or $X_4$ capable of splitting upon reaction with an oxidation product of a color developing agent represents a halogen atom, alkoxy, aryloxy, heterocyclic oxy, acyloxy, sulfonyloxy, alkoxycarbonyloxy, aryloxycarbonyl, alkyloxalyloxy, alkoxyoxalyloxy, alkylthio, arylthio, heterocyclic thio, alkoxycarbonylthio, acylamino, sulfonamido, alkoxycarbonylamino, aryloxycarbonylamino or carboxyl group, or a nitrogen-containing heterocyclic group bonding at an N position.

**3.** The material of claim 1, wherein the yellow image forming silver halide emulsion layer comprises a blue-sensitive silver halide emulsion, the magenta image forming silver halide emulsion layer comprises a green-sensitive silver halide emulsion and the cyan image forming silver halide emulsion layer comprises a red-sensitive silver halide emulsion.

**4.** The material of claim 3, wherein said yellow, magenta and cyan image forming silver halide emulsion layers further contain said fourth silver halide emulsion having at least a portion of a spectral sensitivity wavelength region of said yellow image forming silver halide emulsion layer, at least a portion of a spectral sensitivity wavelength region of a magenta image forming silver halide emulsion layer and at least a portion of a spectral sensitivity wavelength region of the cyan image forming silver halide emulsion layer.

**5.** The material of claim 1, wherein a hydrophilic colloid layer containing a white pigment is provided between the support and the silver halide emulsion layer located closest to the support.

**6.** The material of claim 1, wherein the material is of direct positive type.

**7.** A silver halide color photographic material comprising a support and provided thereon, a yellow image forming silver halide emulsion layer comprising a first silver halide emulsion, a magenta image forming silver halide emulsion layer comprising a second silver halide emulsion, a cyan image forming silver halide emulsion layer comprising a third silver halide emulsion; characterised in that said silver halide color photographic material further comprises a panchromatic emulsion layer forming a red-light absorbing image, wherein the cyan image forming silver halide emulsion layer contains at least one selected from compounds represented by the following Formulas I, II, III and IV:

Formula I

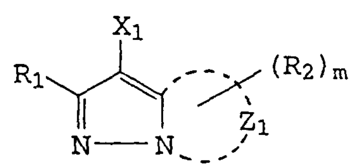

Formula II

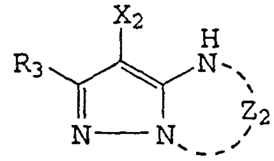

Formula III

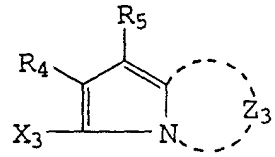

Formula IV

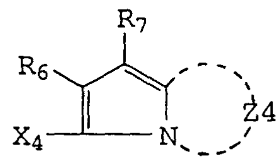

wherein $R_1$ represents a hydrogen or a substituent; $R_2$ represents a substituent; m represents the number of $R_2$, provided that when m is 0, $R_1$ represents an electron attractive group having a Hammett's substituent constant σp of not less than 0.20, and when m is 1 or 2, one of $R_1$ and $R_2$ represents an electron attractive group having a Hammett's substituent constant σp of not less than 0.20; and $Z_1$ represents a group of non-metallic atoms necessary to form a nitrogen -containing 5-membered heterocyclic ring; $R_3$ represents a hydrogen atom or a substituent; $Z_2$ represents a group of non-metallic atoms necessary to condense with a pyrazole ring together with -NH- to form a nitrogen-containing 6-membered heterocyclic ring; $R_4$ and $R_5$ independently represent an electron attractive group having a Hammett's substituent constant σp of not less than 0.20, provided that the total σp value of $R_4$ and $R_5$ is not less than 0.65; $Z_3$ is a group of non-metallic atoms necessary to form a nitrogen-containing 5-membered heterocyclic ring; $R_6$ and $R_7$ independently represent a hydrogen atom or a substituent; $Z_4$ is a group of non-metallic atoms necessary to form a nitrogen-containing 6-membered ring; and $X_1$, $X_2$, $X_3$ and $X_4$ independently represent a hydrogen atom or a group capable of splitting upon coupling reaction with an oxidized product of a color developing agent.

**8.** The material of claim 7, wherein the panchromatic emulsion layer is a layer for forming an image having a red-light density of 0.1 to 1.6 to a 620 to 680 nm light.

**9.** The material of claim 8, wherein the red-light has a wavelength of 620 to 680 nm.

**10.** The material of claim 7, wherein the material is of direct positive type.

## Patentansprüche

**1.** Farbphotographisches Silberhalogenid-Aufzeichnungsmaterial, umfassend einen Schichtträger und - darauf vorgesehen - eine ein gelbes Bild liefernde Silberhalogenidemulsionsschicht mit einer ersten Silberhalogenidemulsion, eine ein purpurrotes Bild liefernde Silberhalogenidemulsionsschicht mit einer zweiten Silberhalogenidemulsion und eine ein blaugrünes Bild liefernde Silberhalogenidemulsionsschicht mit einer dritten Silberhalogenidemulsion, wobei die erste, zweite und dritte der Emulsionen voneinander verschiedene spektrale Empfindlichkeitswellenlängenbereiche aufweisen,
dadurch gekennzeichnet, dass

mindestens eine der die gelben, purpurroten und blaugrünen Bilder liefernden Silberhalogenidemulsionsschichten zusätzlich eine vierte Silberhalogenidemulsion enthält, die zumindest einen Teil des spektralen Empfindlichkeitswellenlängenbereichs der das gelbe Bild liefernden Silberhalogenidemulsionsschicht, zumindest einen Teil des spektralen Empfindlichkeitswellenlängenbereichs einer ein purpurrotes Bild liefernden Silberhalogenidemulsionsschicht und zumindest einen Teil des spektralen Empfindlichkeitswellenlängenbereichs der das blaugrüne Bild liefernden Silberhalogenidemulsionsschicht dergestalt, dass das Empfindlichkeitsverhältnis vierte Silberhalogenidemulsion/erste, zweite und dritte Silberhalogenidemulsion 1/10 bis 10 beträgt, aufweist, und
dass die das blaugrüne Bild liefernde Silberhalogenidemulsionsschicht mindestens eine aus den Verbindungen der folgenden Formel I, II, III und IV:

Formel I

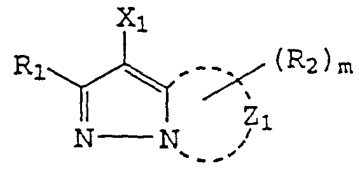

Formel II

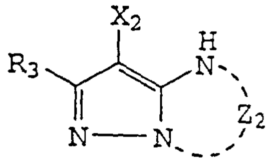

Formel III

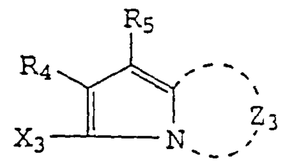

oder

Formel IV

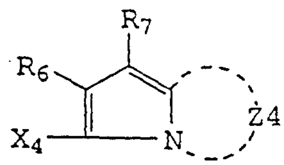

worin bedeuten:

$R_1$ Wasserstoff oder einen Substituenten;
$R_2$ einen Substituenten;
m die Anzahl der Reste $R_2$, wobei gilt, dass im Falle, dass m = 0, der durch $R_1$ dargestellte Substituent für eine elektronenanziehende Gruppe mit einer Hammett'schen Substituentenkonstante $\sigma p$ von nicht weniger als 0,20 steht, und im Falle, dass m = 1 oder 2, einer der Reste $R_1$ und $R_2$ für eine elektronenanziehende Gruppe einer Hammett'schen Substituentenkonstante $\sigma p$ von nicht weniger als 0,20 steht;
$Z_1$ eine zur Bildung eines stickstoffhaltigen 5-gliedrigen heterocyclischen Rings erforderliche Gruppe nichtmetallischer Atome;
$R_3$ ein Wasserstoffatom oder einen Substituenten;
$Z_2$ eine Gruppe nichtmetallischer Atome, die bei Kondensation mit einem Pyrazolring zusammen mit (der Gruppe) -NH- zur Bildung eines stickstoffhaltigen 6-gliedrigen heterocyclischen Rings erforderlich ist;
$R_4$ und $R_5$ unabhängig voneinander eine elektronenanziehende Gruppe mit einer Hammettschen Substituentenkonstante $\sigma p$ von nicht weniger als 0,20, wobei gilt, dass der Gesamt-$\sigma p$-Wert von $R_4$ und $R_5$ nicht weniger als 0,65 beträgt;
$Z_3$ eine zur Bildung eines stickstoffhaltigen 5-gliedrigen heterocyclischen Rings erforderliche Gruppe nichtmetallischer Atome;
$R_6$ und $R_7$ unabhängig voneinander ein Wasserstoffatom oder einen Substituenten;

$Z_4$ eine zur Bildung eines stickstoffhaltigen 6-gliedrigen Rings erforderliche Gruppe nichtmetallischer Atome, und

$X_1$, $X_2$, $X_3$ und $X_4$ unabhängig voneinander ein Wasserstoffatom oder eine bei der Kupplungsreaktion mit einem Oxidationsprodukt einer Farbentwicklerverbindung abspaltbare Gruppe ausgewählte Verbindung enthält.

**2.** Aufzeichnungsmaterial nach Anspruch 1, wobei der durch $R_1$ oder $R_2$ dargestellte Substituent mit einer Hammett-schen Substituentenkonstante $\sigma$p von nicht weniger als 0,20 aus einer Sulfonyl-, Sulfinyl-, Sulfonyloxy-, Sulfamoyl-, Phosphoryl-, Carbamoyl-, Acyl-, Acyloxy-, Oxycarbonyl-, Carboxyl-, Cyano-, Nitro-, halogenierten Alkyl-, halogenierten Alkoxy-, halogenierten Aryloxy-, Pyrrolyl- oder Tetrazolylgruppe oder einem Halogenatom besteht; die durch $R_1$ und $R_2$ dargestellten und von den Substituenten mit einer Hammett'schen Substituentenkonstante $\sigma$p von nicht weniger als 0,20 verschiedenen Substituenten aus einer Alkyl-, Aryl-, Ani-lino-, Acylamino-, Sulfonamido-, Alkylthio-, Arylthio-, Alkenyl-, Cycloalkyl-, Cycloalkenyl-, Alkinyl-, heterocyclischen Gruppe, Alkoxy-, Aryloxy-, Heterocyclusoxy-, Siloxy-, Amino-, Alkylamino-, Imido-, Ureido-, Sulfamoylamino-, Alkoxycarbonylamino-, Aryloxycarbonylamino-, Alkoxycarbonyl-, Aryloxycarbonyl-, Heterocyclusthio-, Thioureido-, Hydroxy- oder Mercaptogruppe, den Resten aus einer Spiroverbindung oder den Resten einer vernetzten Kohlenwassertoffverbindung bestehen; der mit Hilfe von $Z_1$ gebildete 5-gliedrige heterocyclische Ring aus einem Pyrazol-, Imidazol-, Benzimidazol-, Triazol- oder Tetrazolring besteht; der durch $R_3$ dargestellte Substituent aus einer Alkyl-, Aryl-, Anilino-, Acylamino-, Sulfonamido-, Alkylthio-, Arylthio-, Alkenyloder Cycloalkylgruppe, einem Halogenatom, einer Cycloalkenyloder Alkinylgruppe, einer heterocyclischen Gruppe, einer Sulfonyl-, Sulfinyl-, Phosphonyl-, Acyl-, Carbamoyl-, Sulfamoyl-, Cyano-, Alkoxy-, Sulfonyloxy-, Aryloxy-, Heterocyclusoxy-, Siloxy-, Acyloxy-, Carbamoyloxy-, Amino-, Alkylamino-, Imido-, Ureido-, Sulfamoylamino-, Alkoxycarbonylamino-, Aryloxycarbonylamino-, Alkoxycarbonyl-, Aryloxycarbonyl-, Heterocyclusthio-, Thioureido-, Carboxyl-, Hydroxyl-, Mercapto-, Nitro- oder Sulfogruppe, dem Rest aus einer Spiroverbindung oder dem Rest aus einer vernetzten Kohlenwasserstoffverbindung besteht; der mit Hilfe von $Z_2$ gebildete stickstoffhaltige 6-gliedrige heterocyclische Ring aus einer Gruppe mit zwei Stickstoffatomen und einer Carbonylgruppe besteht; $R_4$ und $R_5$ unabhängig voneinander für eine Sulfonyl-, Sulfinyl-, Sulfonyloxy-, Sulfamoyl-, Phosphoryl-, Carbamoyl-, Acyl-, Acyloxy-, Oxycarbonyl-, Carboxyl-, Cyano-, Nitro-, halogenierte Alkyl-, halogenierte Alkoxy-, halogenierte Aryloxy-, Pyrrolyl- oder Tetrazolylgruppe oder ein Halogenatom stehen; der mit Hilfe von $Z_3$ gebildete stickstoffhaltige 5-gliedrige heterocyclische Ring aus einem Pyrazol-, Imidazol- oder Tetrazolring besteht; die durch $R_6$ und $R_7$ dargestellten Substituenten aus einer Alkyl-, Aryl-, Anilino-, Acylamino-, Sulfonamido-, Alkylthio-, Arylthio-, Alkenyloder Cycloalkylgruppe, einem Halogenatom, einer Cycloalkenyloder Alkinylgruppe, einer heterocyclischen Gruppe, einer Sulfonyl-, Sulfinyl-, Phosphonyl-, Acyl-, Carbamoyl-, Sulfamoyl-, Cyano-, Alkoxy-, Sulfonyloxy-, Aryloxy-, Heterocyclusoxy-, Siloxy-, Acyloxy-, Carbamoyloxy-, Amino-, Alkylamino-, Imido-, Ureido-, Sulfamoylamino-, Alkoxycarbonylamino-, Aryloxycarbonylamino-, Alkoxycarbonyl-, Aryloxycarbonyl-, Heterocyclusthio-, Thioureido-, Carboxyl-, Hydroxyl-, Mercapto-, Nitro- oder Sulfogruppe, dem Rest aus einer Spiroverbindung oder dem Rest aus einer vernetzten Kohlenwasserstoffverbindung bestehen; der mit Hilfe von $Z_4$ gebildete stickstoffhaltige 6-gliedrige heterocyclische Ring eine Dissoziationsgruppe mit einem $pK_a$-Wert von 3 bis 12 aufweist, und die durch $X_1$, $X_2$, $X_3$ oder $X_4$ dargestellte und zur Abspaltung bei der Reaktion mit einem Oxidationsprodukt einer Farbentwicklerverbindung fähige Gruppe aus einem Halogenatom, einer Alkoxy-, Aryloxy-, Heterocyclusoxy-, Acyloxy-, Sulfonyloxy-, Alkoxycarbonyloxy-, Aryloxycarbonyl-, Alkyloxalyloxy-, Alkoxyoxalyloxy-, Alkylthio-, Arylthio-, Heterocyclusthio-, Alkoxycarbonylthio-, Acylamino-, Sulfonamido-, Alkoxycarbonylamino-, Aryloxycarbonylamino- oder Carboxylgruppe oder einer in N-Stellung gebundenen stickstoffhaltigen heterocyclischen Gruppe besteht.

**3.** Aufzeichnungsmaterial nach Anspruch 1, wobei die das gelbe Bild liefernde Silberhalogenidemulsionsschicht eine blauempfindliche Silberhalogenidemulsion, die das purpurrote Bild liefernde Silberhalogenidemulsionsschicht eine grünempfindliche Silberhalogenidemulsion und die das blaugrüne Bild liefernde Silberhalogenidemulsionsschicht eine rotempfindliche Silberhalogenidemulsion umfassen.

**4.** Aufzeichnungsmaterial nach Anspruch 3, wobei die die gelben, purpurroten und blaugrünen Bilder liefernden Silberhalogenidemulsionsschichten zusätzlich die vierte Silberhalogenidemulsion mit zumindest einem Teil des spektralen Empfindlichkeitswellenlängenbereichs der das gelbe Bild liefernden Silberhalogenidemulsionsschicht, zumindest einem Teil des spektralen Empfindlichkeitswellenlängenbereichs einer ein purpurrotes Bild liefernden Silberhalogenidemulsionsschicht und zumindest einen Teil des spektralen Empfindlichkeitswellenlängenbereichs der das blaugrüne Bild liefernden Silberhalogenidemulsionsschicht enthalten.

**5.** Aufzeichnungsmaterial nach Anspruch 1, wobei zwischen dem Schichtträger und der dem Schichtträger nächst gelegenen Silberhalogenidemulsionsschicht eine hydrophile Kolloidschicht mit einem weißen Pigment vorgesehen

ist.

6. Aufzeichnungsmaterial nach Anspruch 1, wobei dieses vom direktpositiven Typ ist.

7. Farbphotographisches Silberhalogenid-Aufzeichnungsmaterial, umfassend einen Schichtträger und - darauf vorgesehen - eine ein gelbes Bild liefernde Silberhalogenidemulsionsschicht mit einer ersten Silberhalogenidemulsion, eine ein purpurrotes Bild liefernde Silberhalogenidemulsionsschicht mit einer zweiten Silberhalogenidemulsion und eine ein blaugrünes Bild liefernde Silberhalogenidemulsionsschicht mit einer dritten Silberhalogenidemulsion, dadurch gekennzeichnet, dass das betreffende farbphotographische Silberhalogenid5 Aufzeichnungsmaterial zusätzlich eine ein rotes Licht absorbierendes Bild liefernde panchromatische Emulsionsschicht umfasst und dass die das blaugrüne Bild liefernde Silberhalogenidemulsionsschicht mindestens eine aus den Verbindungen der folgenden Formeln I, II, III und IV:

Formel I

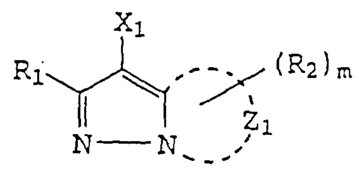

Formel II

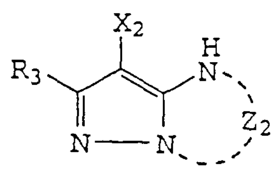

Formel III

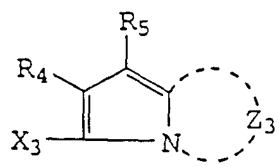

oder

Formel IV

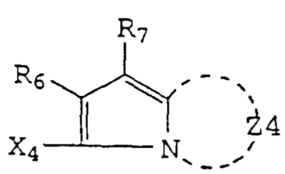

worin bedeuten:

$R_1$ Wasserstoff oder einen Substituenten;
$R_2$ einen Substituenten;
m die Anzahl der Reste $R_2$, wobei gilt, dass im Falle, dass m = 0, $R_1$ für eine elektronenanziehende Gruppe mit einer Hammettschen Substituentenkonstante σp von nicht weniger als 0,20 steht, und im Falle, dass m = 1 oder 2, einer der Reste $R_1$ und $R_2$ für eine elektronenanziehende Gruppe einer Hammettschen Substituentenkonstante σp von nicht weniger als 0,20 steht;
$Z_1$ eine zur Bildung eines stickstoffhaltigen 5-gliedrigen heterocyclischen Rings erforderliche Gruppe nichtmetallischer Atome;
$R_3$ ein Wasserstoffatom oder einen Substituenten;
$Z_2$ eine Gruppe nichtmetallischer Atome, die bei Kondensation mit einem Pyrazolring zusammen mit (der Gruppe) -NH- zur Bildung eines stickstoffhaltigen 6-gliedrigen heterocyclischen Rings erforderlich ist;
$R_4$ und $R_5$ unabhängig voneinander eine elektronenanziehende Gruppe mit einer Hammettschen Substituentenkonstante σp von nicht weniger als 0,20, wobei gilt, dass der Gesamt-σp-Wert von $R_4$ und $R_5$ nicht weniger als 0,65 beträgt;
$Z_3$ eine zur Bildung eines stickstoffhaltigen 5-gliedrigen heterocyclischen Rings erforderliche Gruppe nichtmetallischer Atome;
$R_6$ und $R_7$ unabhängig voneinander ein Wasserstoffatom oder einen Substituenten;
$Z_4$ eine zur Bildung eines stickstoffhaltigen 6-gliedrigen Rings erforderliche Gruppe nichtmetallischer Atome, und
$X_1$, $X_2$, $X_3$ und $X_4$ unabhängig voneinander ein Wasserstoffatom oder eine bei der Kupplungsreaktion mit einem Oxidationsprodukt einer Farbentwicklerverbindung abspaltbare Gruppe ausgewählte Verbindung enthält.

**8.** Aufzeichnungsmaterial nach Anspruch 7, wobei es sich bei der panchromatischen Emulsionsschicht um eine Schicht zur Erzeugung eines Bildes mit einer Rotlichtdichte von 0,1 bis 1,6 für Licht von 620 bis 680 nm handelt.

**9.** Aufzeichnungsmaterial nach Anspruch 8, wobei das rote Licht eine Wellenlänge von 620 bis 680 nm aufweist.

**10.** Aufzeichnungsmaterial nach Anspruch 7, wobei es sich bei dem Aufzeichnungsmaterial um ein solches vom direktpositiven Typ handelt.

**Revendications**

**1.** Un matériau photographique couleur à base d'halogénure d'argent, comprenant un support, et, appliquées sur ce dernier, une couche d'émulsion à l'halogénure d'argent formant une image jaune, comprenant une première émulsion à l'halogénure d'argent, une couche d'émulsion à l'halogénure d'argent formant une image magenta comprenant une deuxième émulsion à l'halogénure d'argent et une couche d'émulsion à l'halogénure d'argent formant une image cyan comprenant une troisième émulsion à l'halogénure d'argent,

lesdites première, seconde et troisième émulsions ayant des régions de longueur d'onde de sensibilité spectrale différentes les unes des autres ;

caractérisé en ce que :

au moins une desdites couches d'émulsion à l'halogénure d'argent formant des images jaune, magenta et cyan contient en outre une quatrième émulsion à l'halogénure d'argent ayant au moins une partie d'une région de longueur d'onde de sensibilité spectrale de ladite couche d'émulsion à l'halogénure d'argent formant une image jaune, au moins une partie d'une région de longueur d'onde de sensibilité spectrale de la couche d'émulsion à l'halogénure d'argent formant une image magenta et au moins une partie d'une région de longueur d'onde de sensibilité spectrale de la couche d'émulsion à l'halogénure d'argent formant une image cyan pour donner un rapport de sensibilité de ladite quatrième émulsion à l'halogénure d'argent à celle desdites première, deuxième et troisième émulsions à l'halogénure d'argent de 1/10 à 10,
dans lequel la couche d'émulsion à l'halogénure d'argent formant une image cyan contient au moins l'un des composés choisi parmi les composés représentés par les formules suivantes I, II, III et IV :

Formule I

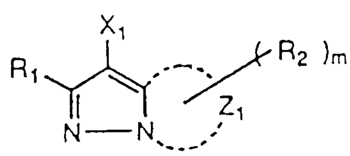

Formule II

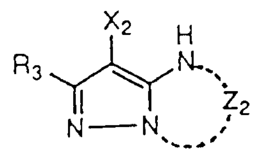

Formule III

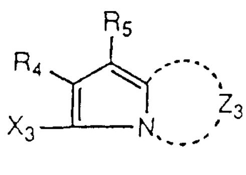

Formule IV

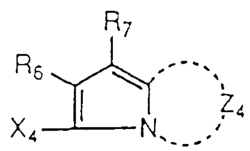

dans lesquelles $R_1$ représente un hydrogène ou un substituant ; $R_2$ représente un substituant ; m représente le nombre de $R_2$, à condition que quand m vaut 0, le substituant de $R_1$ représente un groupe attracteur d'électrons (ou electro-attracteur) ayant une constante de substitution de Hammett $\sigma_p$ non inférieure à 0,20, et quand m vaut 1 ou 2, l'un de $R_1$ et $R_2$ représente un groupe attracteur d'électrons ayant une constante de substitution de Hammett $\sigma_p$ non inférieure à 0,20, et $Z_1$ représente un groupe d'atomes non métalliques nécessaires pour former un hétérocycle à 5 chaînons contenant de l'azote ; $R_3$ représente un atome d'hydrogène ou un substituant ; $Z_2$ représente un groupe d'atomes non métalliques nécessaire pour la condensation avec un noyau pyrazole avec -NH- pour former un hétérocycle à 6 chaînons contenant de l'azote ; $R_4$ et $R_5$ représentent indépendamment un groupe attracteur d'électrons ayant une constante de substitution de Hammett $\sigma_p$ non inférieure à 0,20, à condition que la valeur de $\sigma_p$ totale de $R_4$ et $R_5$ ne soit pas inférieure à 0,65 ; $Z_3$ est un groupe d'atomes non-métalliques nécessaires pour former un hétérocycle à 5 chaînons contenant de l'azote ; $R_6$ et $R_7$ représentent indépendamment un atome d'hydrogène ou un substituant; $Z_4$ est un groupe d'atomes non métalliques nécessaires pour former un cycle à 6 chaînons contenant de l'azote ; et $X_1$, $X_2$, $X_3$ et $X_4$ représentent indépendamment un atome d'hydrogène ou un groupe capable de se couper par réaction de couplage avec un produit oxydé d'un agent de développement de couleur.

**2.** Le matériau selon la revendication 1, dans lequel le substituant de $R_1$ ou $R_2$ ayant une constante de substitution de Hammett $\sigma p$ non inférieure à 0,20 représente un groupement sulfonyle, sulfinyle, sulfonyloxy, sulfamoyle, phosphoryle, carbamoyle, acyle, acyloxy, oxycarbonyle, carboxyle, cyano, nitro, alkyle halogéné, alkoxy halogéné, aryloxy halogéné, pyrrolyle ou tetrazolyle, ou un atome d'halogène ; les substituants de $R_1$ et $R_2$ autres que les substituants ayant une constante de substitution de Hammett $\sigma_p$ non inférieure à 0,20 représentent un groupement alkyle, aryle, anilino, acylamino, sulfonamido, alkylthio, arylthio, akényle, cycloalkyle, cycloalkényle, akynyle, hétérocyclique, alkoxy, aryloxy, hétérocyclique oxy, siloxy, amino, alkylamino, imido, uréido, sulfamoylamino, alkoxycarbonylamino, aryloxycarbonylamino, alkoxycarbonyle, aryloxycarbonyle, hétérocyclique thio, thiouréido, hydroxy ou mercapto, les résidus de composé spiro ou les résidus de composés hydrocarbonés réticulés ; l'hétérocycle à 5 chaînons contenant de l'azote formé avec $Z_1$ représente un pyrazole, un imidazole, un benzimidazole, un triazole ou un noyau tétrazole ; le substituant de $R_3$ représente un groupement alkyle, aryle, anilino, acylamino, sulfonamido, alkylthio, arylthio, akényle ou cycloalkyle, un atome d'halogène, un groupement cycloalkényle, alkynyle, hétérocyclique, sulfonyle, sulfinyle, phosphonyle, acyle, carbamoyle, sulfamoyle, cyano, alkoxy, sulfonyloxy, aryloxy, heterocyclicoxy, siloxy, acyloxy, sulfonyloxy, aryloxy, heterocyclicoxy, siloxy, acyloxy, carbamoyloxy, amino,

alkylamino, imido, ureido, sulfamoylamino, alkoxycarbonylamino, aryloxycarbonylamino, alkoxycarbonyle, aryloxycarbonyle, heterocyclique thio, thiouréido, carboxyle, hydroxyle, mercapto, nitro ou sulfo, un résidu de composé spiro ou un résidu de composé hydrocarboné réticulé ; l'hétérocycle à 6 chaînons contenant de l'azote formé avec $Z_2$ représente un groupement contenant deux atomes d'azote et un groupe carbonyle ; $R_4$ et $R_5$ représentent indépendamment un groupement sulfonyle, sulfinyle, sulfonyloxy, sulfamoyle, phosphoryle, carbamoyle, acyle, acyloxy, oxycarbonyle, carboxyle, cyano, nitro, alkyle halogéné, alkoxy halogéné, aryloxy halogéné, pyrrolyle ou tetrazolyle, ou un atome d'halogène; l'hétérocycle à 5 chaînons contenant de l'azote formé avec $Z_3$ représente un pyrazole, un imidazole ou un noyau tétrazole ; le substituant de $R_6$ ou $R_7$ représente un groupement alkyle, aryle, anilino, acylamino, sulfonamido, alkylthio, arylthio, alkényle ou cycloalkyle, un atome d'halogène, un groupement cycloalkényle, alkynyle, hétérocyclique, sulfonyle, sulfinyle, phosphonyle, acyle, carbamoyle, sulfamoyle, cyano, alkoxy, sulfonyloxy, aryloxy, heterocyclique oxy, siloxy, acyloxy, carbamoyloxy, amino, alkylamino, imido, ureido, sulfamoylamino, alkoxycarbonylamino, aryloxycarbonylamino, alkoxycarbonyle, aryloxycarbonyle, heterocyclicthio, thiouréido, carboxyle, hydroxyle, mercapto, nitro ou sulfo, un résidu de composé spiro ou un résidu de composé hydrocarboné réticulé ; l'hétérocycle à 6 chaînons contenant de l'azote formé avec $Z_4$ comporte un groupement dissociable ayant un $pK_a$ de 3 à 12 ; et le groupement représenté par $X_1$, $X_2$, $X_3$ ou $X_4$ capable de se couper par réaction de couplage avec un produit d'oxydation d'un agent de développement de couleur représente un atome d'halogène, un groupement alkoxy, aryloxy, héterocyclique oxy, acyloxy, sulfonyloxy, alkoxycarbonyloxy, aryloxycarbonyle, alkyloxalyloxy, alkoxyoxalyloxy, alkylthio, arylthio, hétérocyclique thio, alkoxycarbonylthio, acylamino, sulfonamido, alkoxycarbonylamino, aryloxycarbonylamino ou carboxyle, ou un groupement hétérocyclique contenant de l'azote se liant à une position N.

**3.** Le matériau selon la revendication 1, dans lequel la couche d'émulsion à l'halogénure d'argent formant une image jaune comprend une émulsion à l'halogénure d'argent sensible au bleu, la couche d'émulsion à l'halogénure d'argent formant une image magenta comprend une émulsion à l'halogénure d'argent sensible au vert et la couche d'émulsion à l'halogénure d'argent formant une image cyan comprend une émulsion à l'halogénure d'argent sensible au rouge.

**4.** Le matériau selon la revendication 3, dans lequel, lesdites couches d'halogénure d'argent formant des images jaune, magenta et cyan contiennent en outre une quatrième émulsion à l'halogénure d'argent ayant au moins une partie de la région de longueur d'onde de sensibilité spectrale de ladite la couche d'émulsion à l'halogénure d'argent formant une image jaune, au moins une partie de la région de longueur d'onde de sensibilité spectrale de la couche d'émulsion à l'halogénure d'argent formant une image magenta et au moins une partie de la région de longueur d'onde de sensibilité spectrale de ladite la couche d'émulsion à l'halogénure d'argent formant une image cyan.

**5.** Le matériau selon la revendication 1, dans lequel une couche colloïde hydrophile contenant un pigment blanc est appliquée entre le support et la couche d'émulsion à l'halogénure d'argent qui est située le plus près possible du support.

**6.** Le matériau selon la revendication 1, dans lequel le support est du type positif direct.

**7.** Un matériau photographique couleur à base d'halogénure d'argent, comprenant un support, et, appliquées sur ce dernier, une couche d'émulsion à l'halogénure d'argent formant une image jaune comprenant une première émulsion à l'halogénure d'argent, une couche d'émulsion à l'halogénure d'argent formant une image magenta comprenant une deuxième émulsion à l'halogénure d'argent, une couche d'émulsion à l'halogénure d'argent formant une image cyan comprenant une troisième émulsion à l'halogénure d'argent ; caractérisé en ce que ledit substrat photographique couleur à l'halogénure d'argent comprend en outre une couche d'émulsion panchromatique formant une image absorbant la lumière rouge, dans laquelle la couche d'émulsion à l'halogénure d'argent formant une image cyan contient au moins un composé choisi parmi les composés représentés par les formules suivantes I, II, III et IV :

Formule I

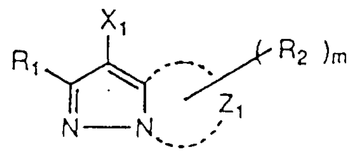

Formule II

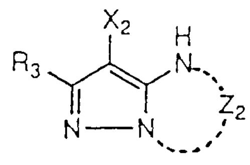

Formule III

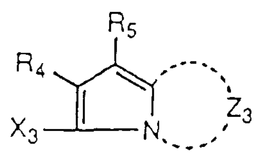

Formule IV

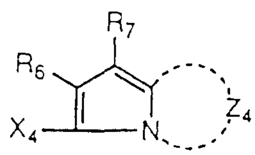

dans lesquelles $R_1$ représente un hydrogène ou un substituant ; $R_2$ représente un substituant ; m représente le nombre de $R_2$, à condition que quand m vaut 0, $R_1$ représente un groupe attracteur d'électrons ayant une constante de substitution de Hammett $\sigma_p$ non inférieure à 0,20, et quand m vaut 1 ou 2, l'un de $R_1$ et $R_2$ représente un groupe attracteur d'électrons ayant une constante de substitution de Hammett $\sigma_p$ non inférieure à 0,20 ; et $Z_1$ représente un groupement d'atomes non-métalliques nécessaires pour former un noyau hétérocyclique à 5 chaînons contenant de l'azote ; $R_3$ représente un atome d'hydrogène ou un substituant ; $Z_2$ représente un groupement d'atomes non-métalliques nécessaires pour la condensation avec un noyau pyrazole avec -NH- pour former un hétérocycle à 6 chaînons contenant de l'azote ; $R_4$ et $R_5$ représentent indépendamment un groupe attracteur d'électrons ayant une constante de substitution de Hammett $\sigma_p$ non inférieure à 0,20, à condition que que la valeur de $\sigma_p$ totale de $R_4$ et $R_5$ ne soit pas inférieure à 0,65 ; $Z_3$ est un groupe d'atomes non-métalliques nécessaires pour former un hétérocycle à 5 chaînons contenant de l'azote ; $R_6$ et $R_7$ représentent indépendamment un atome d'hydrogène ou un substituant ; $Z_4$ est un groupe d'atomes non métalliques nécessaires pour former un cycle à 6 chaînons contenant de l'azote ; et $X_1$, $X_2$, $X_3$ et $X_4$ représentent indépendamment un atome d'hydrogène ou un groupe capable de se couper par réaction de couplage avec un produit oxydé d'un agent de développement de couleur.

**8.** Le matériau selon la revendication 7, dans lequel la couche d'émulsion panchromatique est une couche pour former une image ayant une densité à la lumière rouge de 0,1 à 1,6 pour un rayonnement de 620 à 680 nm.

**9.** Le matériau selon la revendication 8, dans lequel la lumière rouge a une longueur d'onde de 620 à 680 nm.

**10.** Le matériau selon la revendication 7, dans lequel le substrat est du type positif direct.